# EUROPEAN PATENT APPLICATION

(11) **EP 4 716 036 A1**
(43) Date of publication of application: **25.03.2026**
(21) Application number: 24810748.4
(22) Date of filing: 10.04.2024
(51) Int. Cl.: H01S 5/183, H01L 33/08, H01L 33/38, H01L 33/62, H01S 5/0234, H01S 5/042, H01S 5/22, H01S 5/42

(54) **SURFACE LIGHT-EMITTING ELEMENT AND LIGHT SOURCE DEVICE**

(30) Priority: 19.05.2023 JP 2023082790
(71) Applicant: Sony Semiconductor Solutions Corporation, Atsugi-shi, Kanagawa 243-0014 (JP)
(72) Inventor: MASUMOTO, Ichiro, Kikuchi-gun, Kumamoto 869-1102 (JP); YOKOTA, Tomohiro, Kikuchi-gun, Kumamoto 869-1102 (JP); ITO, Ryo, Kikuchi-gun, Kumamoto 869-1102 (JP); KUDO, Hiroki, Kikuchi-gun, Kumamoto 869-1102 (JP); AOYAGI, Hidekazu, Kikuchi-gun, Kumamoto 869-1102 (JP)
(74) Representative: D Young & Co LLP
(86) International application number: PCT/JP2024/014526
(87) International publication number: WO 2024/241740

(57) **Abstract**

A surface emitting element capable of suppressing protrusion of a bump to a side of a light emitting element constituent portion when an electrode provided on a dummy element constituent portion is connected to a substrate via the bump is provided.

The surface emitting element according to the present technology includes: a base portion including a substrate; and a light emitting element constituent portion and a dummy element constituent portion provided to be spaced apart in an in-plane direction on one surface of the base portion, in which an electrode including an external connection surface is provided on the dummy element constituent portion, and a convex portion protruding to a side opposite to a side of the base portion more than the external connection surface is provided in a proximity portion relatively close to the light emitting element constituent portion, of the dummy element constituent portion. According to the surface emitting element according to the present technology, it is possible to provide the surface emitting element capable of suppressing protrusion of the bump to a side of the light emitting element constituent portion in a case where the electrode provided on the dummy element constituent portion is connected to the substrate via the bump.

## Description

### TECHNICAL FIELD

The technology according to the present disclosure (hereinafter, also referred to as "the present technology") relates to a surface emitting element, a light source device, and electronic equipment.

### BACKGROUND ART

In related art, for example, a surface emitting element capable of obtaining a surface emission output such as a surface emitting laser and a light emitting diode is known.

Among surface emitting elements in the related art, there is a surface emitting element including a light emitting element constituent portion and a dummy element constituent portion that are separated from each other in an in-plane direction (see, for example, Patent Document 1).

### CITATION LIST

### PATENT DOCUMENT

Patent Document 1: WO 2020/162390 A

### SUMMARY OF THE INVENTION

### PROBLEMS TO BE SOLVED BY THE INVENTION

However, in the surface emitting element in the related art, there is room for improvement in suppressing protrusion of a bump to a side of the light emitting element constituent portion in a case where an electrode provided on the dummy element constituent portion is connected to a substrate via the bump.

Thus, a main object of the present technology is to provide a surface emitting element capable of suppressing protrusion of a bump to a side of a light emitting element constituent portion in a case where an electrode provided on a dummy element constituent portion is connected to a substrate via the bump.

### SOLUTIONS TO PROBLEMS

The present technology provides a surface emitting element including:
a base portion including a substrate; and
a light emitting element constituent portion and a dummy element constituent portion provided to be spaced apart in an in-plane direction on one surface of the base portion,
in which an electrode including an external connection surface is provided on the dummy element constituent portion, and
a convex portion protruding to a side opposite to a side of the base portion more than the external connection surface is provided in a proximity portion relatively close to the light emitting element constituent portion, of the dummy element constituent portion.

The external connection surface may be a flat surface.

A wiring that covers a portion of the one surface and the proximity portion may be provided.

A portion covering the proximity portion of the wiring may include at least a portion of the convex portion.

The electrode may include at least a portion of the convex portion.

The proximity portion may include at least a portion of the convex portion.

The external connection surface may be continuously provided from the proximity portion to a remote portion relatively far from the light emitting element constituent portion, of the dummy element constituent portion.

At least the remote portion may be covered with a protective film.

The wiring may be covered with a protective film, and the convex portion may include a portion of the protective film.

The wiring may include a first wiring provided on the portion and a second wiring provided on the first wiring.

The second wiring may include conductive plating.

Another electrode may be provided on the light emitting element constituent portion, and the electrode and the other electrode may have the same height of a surface on a side opposite to the side of the base portion.

Both the light emitting element constituent portion and the dummy element constituent portion may have a mesa shape.

Each of the light emitting element constituent portion and the dummy element constituent portion may include at least a portion of a first semiconductor structure arranged on the substrate, a light emitting layer arranged on the first semiconductor structure, and a second semiconductor structure arranged on the light emitting layer.

The light emitting element constituent portion may include a current confinement region provided between a surface of the first semiconductor structure on a side opposite to a side of the light emitting layer and the light emitting layer, and/or between a surface of the second semiconductor structure on a side opposite to the side of the light emitting layer and the light emitting layer.

At least the second semiconductor structure out of the first semiconductor structure and the second semiconductor structure may include a semiconductor multilayer film reflector.

The surface emitting element may emit light to the side opposite to a side of the light emitting element constituent portion of the base portion.

A plurality of at least the light emitting element constituent portions out of the light emitting element constituent portion and the dummy element constituent portion may be provided, and the wiring may be a common wiring common to at least two of the light emitting element constituent portions.

The present technology also provides a light source device including: a surface emitting element including a base portion including a substrate, and a light emitting element constituent portion and a dummy element constituent portion provided to be spaced apart from each other in an in-plane direction on one surface of the base portion, in which an electrode including an external connection surface is provided on the dummy element constituent portion, and a convex portion protruding to a side opposite to a side of the base portion more than the external connection surface is provided in a proximity portion relatively close to the light emitting element constituent portion, of the dummy element constituent portion; and
another substrate, in which
another electrode is provided on the light emitting element constituent portion,
the other electrode and the other substrate are bonded via a first bump, and
the electrode and the other substrate are bonded via a second bump.

A plurality of the second bumps may be provided.

### BRIEF DESCRIPTION OF DRAWINGS

Fig. 1 is a cross-sectional view of a surface emitting element according to Example 1 of one embodiment of the present technology.
Fig. 2 is a plan view of the surface emitting element according to Example 1 of one embodiment of the present technology.
Fig. 3 is a cross-sectional view of a portion of a light emitting element constituent portion array of a surface emitting device including the surface emitting element according to Example 1 of one embodiment of the present technology.
Fig. 4 is a plan view of the surface emitting device including the surface emitting element according to Example 1 of one embodiment of the present technology.
Fig. 5 is a cross-sectional view of a portion including the surface emitting element of a light source device including the surface emitting device including the surface emitting element according to Example 1 of one embodiment of the present technology.
Fig. 6 is a cross-sectional view of a portion including a portion of the light emitting element constituent portion array of the light source device including the surface emitting device including the surface emitting element according to Example 1 of one embodiment of the present technology.
Fig. 7 is a flowchart for describing an example of a method for manufacturing the surface emitting device including the surface emitting element according to Example 1 of one embodiment of the present technology.
Fig. 8 is a cross-sectional view for each process of an example of the method for manufacturing the surface emitting device including the surface emitting element according to Example 1 of one embodiment of the present technology.
Fig. 9 is a cross-sectional view for each process of an example of the method for manufacturing the surface emitting device including the surface emitting element according to Example 1 of one embodiment of the present technology.
Fig. 10 is a cross-sectional view for each process of an example of the method for manufacturing the surface emitting device including the surface emitting element according to Example 1 of one embodiment of the present technology.
Fig. 11 is a cross-sectional view for each process of an example of the method for manufacturing the surface emitting device including the surface emitting element according to Example 1 of one embodiment of the present technology.
Fig. 12 is a cross-sectional view for each process of an example of the method for manufacturing the surface emitting device including the surface emitting element according to Example 1 of one embodiment of the present technology.
Fig. 13 is a cross-sectional view for each process of an example of the method for manufacturing the surface emitting device including the surface emitting element according to Example 1 of one embodiment of the present technology.
Fig. 14 is a cross-sectional view for each process of an example of the method for manufacturing the surface emitting device including the surface emitting element according to Example 1 of one embodiment of the present technology.
Fig. 15 is a cross-sectional view for each process of an example of the method of manufacturing the light source device including the surface emitting device including the surface emitting element according to Example 1 of one embodiment of the present technology.
Fig. 16 is a cross-sectional view for each process of an example of the method of manufacturing the light source device including the surface emitting device including the surface emitting element according to Example 1 of one embodiment of the present technology.
Fig. 17 is a cross-sectional view of a surface emitting element according to Example 2 of one embodiment of the present technology.
Fig. 18 is a plan view of the surface emitting element according to Example 2 of one embodiment of the present technology.
Fig. 19 is a cross-sectional view of a portion including the surface emitting element of a light source device including a surface emitting device including the surface emitting element according to Example 2 of one embodiment of the present technology.
Fig. 20 is a cross-sectional view of a surface emitting element according to Example 3 of one embodiment of the present technology.
Fig. 21 is a plan view of the surface emitting element according to Example 3 of one embodiment of the present technology.
Fig. 22 is a cross-sectional view of a portion including the surface emitting element of a light source device including a surface emitting device including the surface emitting element according to Example 3 of one embodiment of the present technology.
Fig. 23 is a cross-sectional view of a portion including the surface emitting element of another light source device including the surface emitting device including the surface emitting element according to Example 1 of one embodiment of the present technology.
Fig. 24 is a cross-sectional view of a surface emitting element according to Example 4 of one embodiment of the present technology.
Fig. 25 is a cross-sectional view of a surface emitting element according to Example 5 of one embodiment of the present technology.
Fig. 26 is a cross-sectional view of a surface emitting element according to Example 6 of one embodiment of the present technology.
Fig. 27 is a cross-sectional view of a surface emitting element according to Example 7 of one embodiment of the present technology.
Fig. 28 is a cross-sectional view of a surface emitting element according to Example 8 of one embodiment of the present technology.
Fig. 29 is a cross-sectional view of a surface emitting element according to Example 9 of one embodiment of the present technology.
Fig. 30 is a cross-sectional view of a surface emitting element according to Example 10 of one embodiment of the present technology.
Fig. 31 is a cross-sectional view of a surface emitting element according to Example 11 of one embodiment of the present technology.
Fig. 32 is a cross-sectional view of a portion of a light emitting element constituent portion array of a surface emitting device including the surface emitting element according to Example 11 of one embodiment of the present technology.
Fig. 33 is a plan view of the surface emitting device including the surface emitting element according to Example 11 of one embodiment of the present technology.
Fig. 34 is a cross-sectional view of a portion including the surface emitting element of a light source device including the surface emitting device including the surface emitting element according to Example 11 of one embodiment of the present technology.
Fig. 35 is a flowchart for describing an example of a method for manufacturing the surface emitting device including the surface emitting element according to Example 11 of one embodiment of the present technology.
Fig. 36 is a cross-sectional view for each process of an example of the method for manufacturing the surface emitting device including the surface emitting element according to Example 11 of one embodiment of the present technology.
Fig. 37 is a cross-sectional view for each process of an example of the method for manufacturing the surface emitting device including the surface emitting element according to Example 11 of one embodiment of the present technology.
Fig. 38 is a cross-sectional view for each process of an example of the method for manufacturing the surface emitting device including the surface emitting element according to Example 11 of one embodiment of the present technology.
Fig. 39 is a cross-sectional view for each process of an example of the method for manufacturing the surface emitting device including the surface emitting element according to Example 11 of one embodiment of the present technology.
Fig. 40 is a cross-sectional view for each process of an example of the method for manufacturing the surface emitting device including the surface emitting element according to Example 11 of one embodiment of the present technology.
Fig. 41 is a cross-sectional view for each process of an example of the method for manufacturing the surface emitting device including the surface emitting element according to Example 11 of one embodiment of the present technology.
Fig. 42 is a cross-sectional view for each process of an example of the method for manufacturing the surface emitting device including the surface emitting element according to Example 11 of one embodiment of the present technology.
Fig. 43 is a cross-sectional view of a surface emitting element according to Example 12 of one embodiment of the present technology.
Fig. 44 is a cross-sectional view of a surface emitting element according to Example 13 of one embodiment of the present technology.
Fig. 45 is a cross-sectional view of a surface emitting element according to Modification 1 of Example 1 of one embodiment of the present technology.
Fig. 46 is a cross-sectional view of a surface emitting element according to Modification 2 of Example 1 of one embodiment of the present technology.
Fig. 47 is a cross-sectional view of a surface emitting element according to Modification 3 of Example 1 of one embodiment of the present technology.
Fig. 48 is a cross-sectional view of a surface emitting element according to Modification 4 of Example 1 of one embodiment of the present technology.
Fig. 49 is a cross-sectional view of a surface emitting element according to Modification 5 of Example 1 of one embodiment of the present technology.
Fig. 50 is a cross-sectional view of a surface emitting element according to Modification 6 of Example 1 of one embodiment of the present technology.
Fig. 51 is a cross-sectional view of a surface emitting element according to Modification 7 of Example 1 of one embodiment of the present technology.
Fig. 52 is a view illustrating an example in which the surface emitting element according to Example 1 of one embodiment of the present technology is applied to a distance measurement device.
Fig. 53 is a block diagram illustrating an example of a schematic configuration of a vehicle control system.
Fig. 54 is an explanatory diagram illustrating an example of installation positions of the distance measurement device.

### MODE FOR CARRYING OUT THE INVENTION

Hereinafter, preferred embodiments of the present technology will be described in detail with reference to the accompanying drawings. Note that, in the present specification and drawings, components having substantially the same functional configuration are denoted by the same reference numerals, and redundant description is omitted. The embodiments to be described below provide representative embodiments of the present technology, and the scope of the present technology is not to be narrowly interpreted according to those embodiments. In the present specification, even in a case where it is described that the surface emitting element and the light source device according to the present technology exhibit a plurality of effects, it is only necessary that the surface emitting element and the light source device according to the present technology exhibit at least one effect. The effects described in the present specification are merely examples and are not limited, and other effects may be exerted.

Furthermore, description will be provided in the following order.
0. Introduction
1. Surface Emitting Element According to Example 1 of One Embodiment of Present Technology
2. Surface Emitting Element According to Example 2 of One Embodiment of Present Technology
3. Surface Emitting Element According to Example 3 of One Embodiment of Present Technology
4. Surface Emitting Element According to Example 4 of One Embodiment of Present Technology
5. Surface Emitting Element According to Example 5 of One Embodiment of Present Technology
6. Surface Emitting Element According to Example 6 of One Embodiment of Present Technology
7. Surface Emitting Element According to Example 7 of One Embodiment of Present Technology
8. Surface Emitting Element According to Example 8 of One Embodiment of Present Technology
9. Surface Emitting Element According to Example 9 of One Embodiment of Present Technology
10. Surface Emitting Element According to Example 10 of One Embodiment of Present Technology
11. Surface Emitting Element According to Example 11 of One Embodiment of Present Technology
12. Surface Emitting Element According to Example 12 of One Embodiment of Present Technology
13. Surface Emitting Element According to Example 13 of One Embodiment of Present Technology
14. Modifications of Present Technology
15. Application Example to Electronic Equipment
16. Example in which Surface Emitting Element is Applied to Distance Measurement Device
17. Example in which Distance Measurement Device is Mounted on Moving Body

### <0. Introduction>

In related art, for example, a surface emitting element capable of obtaining a surface emission output such as a surface emitting laser and a light emitting diode is known.

A surface emitting element in related art includes a light emitting element constituent portion (for example, a light emitting mesa) and a dummy element constituent portion (for example, a dummy mesa) which are separated from each other in an in-plane direction (for example, see Patent Document 1).

In this surface emitting element, electrodes provided on the light emitting element constituent portion and the dummy element constituent portion are bonded (connected) to a substrate via bumps, so that it is necessary to ensure stable electrical connection between each electrode and the substrate.

In particular, when the electrode provided on the dummy element constituent portion and the substrate are connected via the bump, it is necessary to suppress protrusion of the bump to a side of the light emitting element constituent portion due to the bump being crushed by an excessive load. This is because if the bump protrudes to the side of the light emitting element constituent portion, the light emitting element constituent portion may be eroded.

In the surface emitting element in the related art, there is room for improvement in suppressing protrusion of the bump that connects the electrode provided on the dummy element constituent portion and the substrate to the side of the light emitting element constituent portion.

Thus, as a result of intensive studies, the inventors have developed a surface emitting element according to the present technology as a surface emitting element capable of suppressing protrusion of a bump to a side of a light emitting element constituent portion in a case where an electrode provided on a dummy element constituent portion is connected to a substrate via the bump.

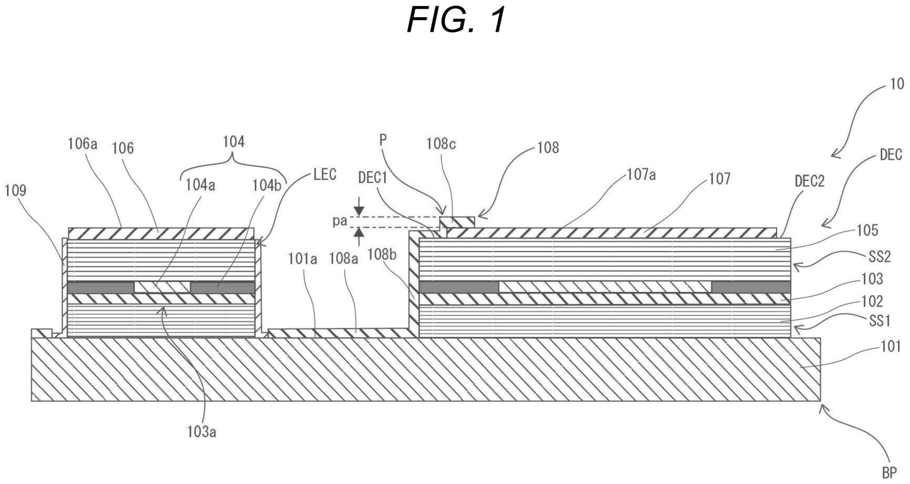

Hereinafter, some examples of one embodiment of the surface emitting element according to the present technology will be described in detail using the drawings. Hereinafter, in the cross-sectional view of Fig. 1, and the like, an upper side will be described as "upper" and a lower side will be described as "lower" as appropriate.

### <1. Surface Emitting Element According to Example 1 of One Embodiment of Present Technology>

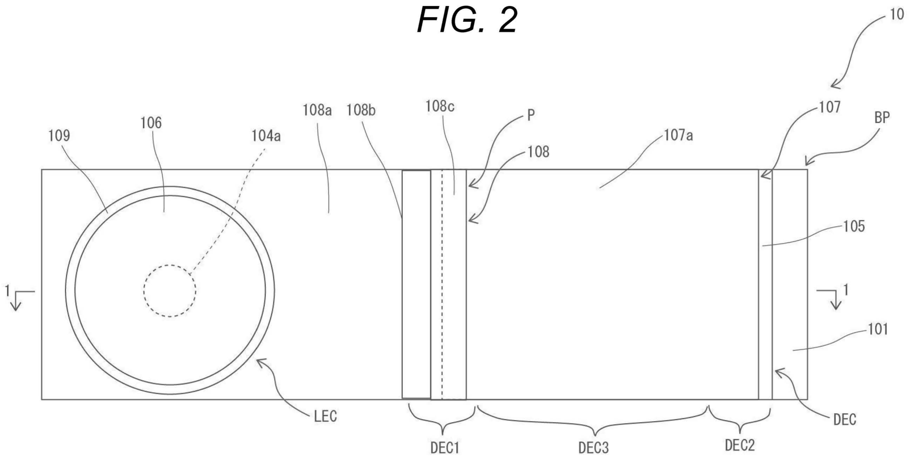

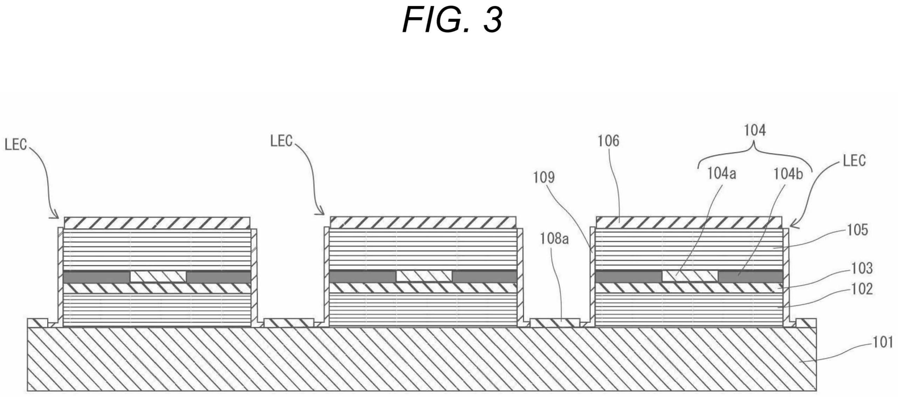

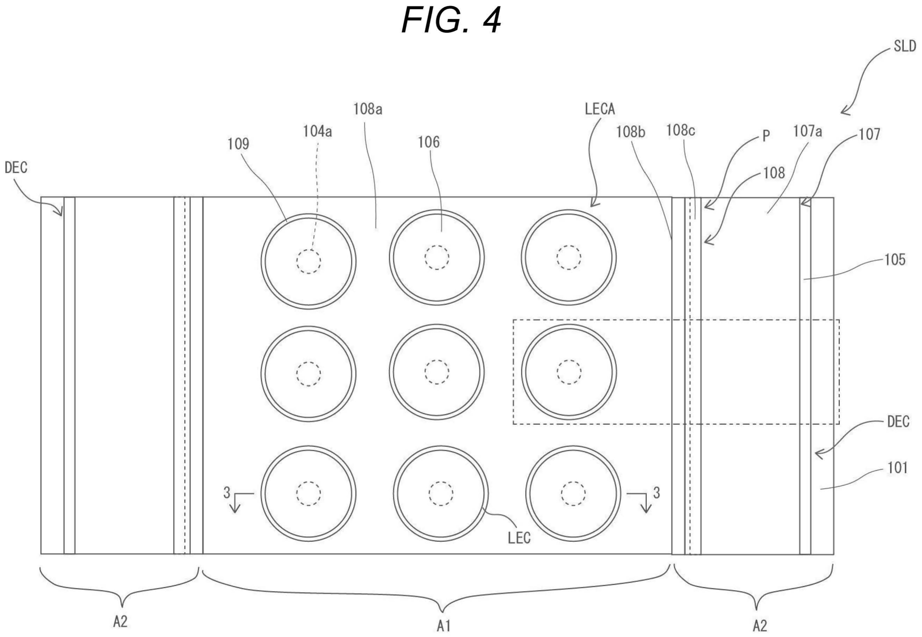

Fig. 1 is a cross-sectional view of a surface emitting element 10 according to Example 1 of one embodiment of the present technology. Fig. 2 is a plan view of the surface emitting element 10 according to Example 1 of one embodiment of the present technology. Fig. 3 is a cross-sectional view of a portion of a light emitting element constituent portion array of a surface emitting device SLD including the surface emitting element 10 according to Example 1 of one embodiment of the present technology. Fig. 4 is a plan view of the surface emitting device SLD including the surface emitting element 10 according to Example 1 of one embodiment of the present technology. Fig. 1 is a cross-sectional view taken along a line 1-1 in Fig. 2. Fig. 2 is a view illustrating an extracted portion surrounded by a two-dot chain line in Fig. 4. Fig. 3 is a cross-sectional view taken along a line 3-3 in Fig. 4.

### <<Configurations of Surface Emitting Element and Light Source Device Including Surface Emitting Element>>

### (Overall Configuration of Surface Emitting Element)

As an example, the surface emitting element 10 according to the present technology constitutes a portion of the surface emitting device SLD illustrated in Fig. 4.

As an example, as illustrated in Fig. 4, the surface emitting device SLD includes a first region A1 including a light emitting element constituent portion array LECA in which a plurality of (for example, nine) light emitting element constituent portions LECs is arranged in an array (for example, a matrix), and a second region A2 including a dummy element constituent portion DEC around the first region A1. Here, in plan view, the first region A1 is sandwiched between the two second regions A2. In each of the second regions A2, the dummy element constituent portion DEC extends in a direction orthogonal to the arrangement direction of the first and second regions A1, A2 so as to correspond to all the light emitting element constituent portions LEC. Note that the second region A2 may be provided only on one side of the first region A1, or may be provided so as to surround the first region A2.

As an example, as illustrated in Figs. 1 and 2, the surface emitting element 10 includes a base portion BP including a substrate 101, and a light emitting element constituent portion LEC and a dummy element constituent portion DEC provided on one surface (upper surface) of the base portion BP so as to be spaced apart in an in-plane direction (lateral direction). The surface emitting element 10 is driven by a driver (drive circuit) as an example.

As an example, the surface emitting element 10 includes at least a plurality of light emitting element constituent portions LEC out of the light emitting element constituent portion LEC and the dummy element constituent portion DEC. Note that the surface emitting element 10 can include one light emitting element constituent portion LEC and at least one dummy element constituent portion DEC.

As an example, the light emitting element constituent portion LEC constitutes at least a portion of a vertical cavity surface emitting laser (VCSEL). The surface emitting element 10 including the VCSEL emits light to a side opposite to a side of the light emitting element constituent portion LEC of the base portion BP. In other words, the VCSEL is, as an example, a backside emission type VCSEL.

As an example, each of the light emitting element constituent portion LEC and the dummy element constituent portion DEC includes at least a portion (for example, all) of a first semiconductor structure SS1 arranged on the substrate 101, a light emitting layer 103 arranged on the first semiconductor structure SS1, and a second semiconductor structure SS2 arranged on the light emitting layer 103.

Furthermore, the light emitting element constituent portion LEC includes, as an example, an oxidation confinement layer 104 including a current confinement region arranged between a surface (upper surface) on a side opposite to the side of the light emitting layer 103 of the second semiconductor structure SS2 and the light emitting layer 103. The dummy element constituent portion DEC also includes a layer corresponding to the oxidation confinement layer 104.

In other words, the light emitting element constituent portion LEC and the dummy element constituent portion DEC have substantially the same layer structure.

As an example, the first semiconductor structure SS1 includes a first semiconductor multilayer film reflector 102.

As an example, the second semiconductor structure SS2 includes a second semiconductor multilayer film reflector 105. The second semiconductor multilayer film reflector 105 is different in conductivity type from the first semiconductor multilayer film reflector 102.

In other words, in the surface emitting element 10, as an example, the first semiconductor multilayer film reflector 102, the light emitting layer 103, the oxidation confinement layer 104, and the second semiconductor multilayer film reflector 105 are stacked in this order on the substrate 101. Note that the stacking order of the light emitting layer 103 and the oxidation confinement layer 104 may be reversed.

The surface emitting element 10 has a double heterostructure in which the light emitting layer 103 is sandwiched between the first semiconductor multilayer film reflector 102 and the second semiconductor multilayer film reflector 105 having different conductivity types in a stacking direction (vertical direction), and can cause radiative recombination of holes and electrons in the light emitting layer 103.

The surface emitting element 10 includes the light emitting layer 103 and first and second semiconductor multilayer film reflectors 102, 105 sandwiching the light emitting layer 103 in the stacking direction to constitute a resonator.

Here, both the light emitting element constituent portion LEC and the dummy element constituent portion DEC have a mesa shape. Thus, hereinafter, the light emitting element constituent portion LEC is also referred to as a "light emitting mesa", and the dummy element constituent portion DEC is also referred to as a "dummy mesa". The dummy mesa is also referred to as a "pedestal portion".

As an example, the light emitting mesa and the dummy mesa have a height of several µm to several tens of µm (for example, about 3 to 10 µm). While a planar view shape of the light emitting mesa is circular here (see Fig. 2), the planar view shape of the light emitting mesa may be, for example, an elliptical shape or a polygonal shape such as a square, a rectangle, a hexagon, or an octagon.

At least a side surface of the light emitting mesa is covered with the insulating film 109 as a protective film. The insulating film 109 includes, for example, a dielectric such as SiO₂, SiN, or SiON.

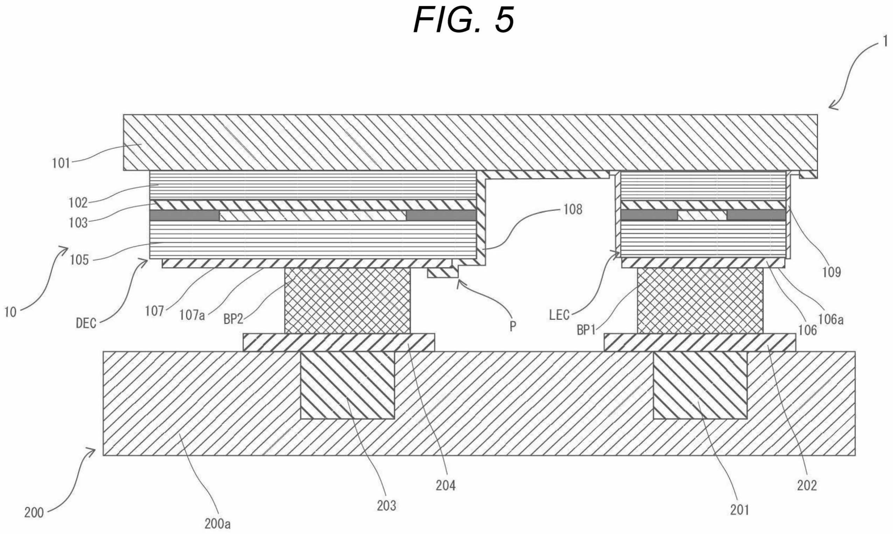

A solid anode electrode 106 including an external connection surface 106a is provided on the light emitting element constituent portion LEC (on the top of the light emitting mesa). The external connection surface 106a is, for example, a flat surface. The external connection surface 106a is bonded to another substrate 200 (such as, for example, a drive substrate and a wiring substrate) via the first bump BP1 (conductive bump) (see Fig. 5).

A solid cathode electrode 107 including the external connection surface 107a is provided on the dummy element constituent portion DEC (on the top of the dummy mesa). The external connection surface 107a is, for example, a flat surface. The external connection surface 107a may have minute irregularities. The external connection surface 107a is bonded to the other substrate 200 (such as, for example, a drive substrate and a wiring substrate) via the second bump BP2 (conductive bump) (see Fig. 5).

The anode electrode 106 and the cathode electrode 107 preferably have the same height of the external connection surface which is a surface (upper surface) opposite to the side of the base portion BP (the external connection surface is on the same plane). Each external connection surface can be rephrased as an "external joint surface", a "bump joint surface", a "bump connection surface", or the like. As an example, the anode electrode 106 and the cathode electrode 107 each have a substantially uniform thickness.

The convex portion P protruding to the side (upper side) opposite to the side of the base portion BP more than the external connection surface 107a is provided in a proximity portion DEC1 relatively close to the light emitting element constituent portion LEC, of the dummy element constituent portion DEC. The proximity portion DEC1 is a portion including a side surface on the side of the light emitting element constituent portion LEC, of the dummy element constituent portion DEC.

The external connection surface 107a is continuously provided from the proximity portion DEC1 to the remote portion DEC2 relatively far from the light emitting element constituent portion LEC, of the dummy element constituent portion DEC, thereby, an area of the external connection surface 107a as a bump joint surface is sufficiently secured. The remote portion DEC2 is a portion including a side surface on the side opposite to the side of the light emitting element constituent portion LEC, of the dummy element constituent portion DEC. The dummy element constituent portion DEC includes an intermediate portion DCE3 between the proximity portion DEC1 and the remote portion DEC2 (see Fig. 2). An interval between the proximity portion DEC1 and the remote portion DEC2, which is the length of an intermediate portion DEC3 in a line 1-1 direction, can be appropriately changed.

The wiring 108 covering a portion of one surface (here, the upper surface 101a of the substrate 101) of the base portion BP (for example, a region around the light emitting element constituent portion LEC) and the proximity portion DEC1 is provided. The wiring 108 is a wiring that makes the base portion BP and the cathode electrode 107 on each dummy element constituent portion DEC favorably conductive with each other. As an example, the wiring 108 is a common wiring common to at least two (for example, nine) light emitting element constituent portions LEC.

As is apparent from the above description, the surface emitting element 10 has an anode-independent and cathode-common electrode layout, and can independently drive each of the light emitting element constituent portions LEC.

### (Substrate)

The substrate 101 includes GaAs (for example, n-GaAs) as an example.

### (First Semiconductor Multilayer Film Reflector)

As an example, the first semiconductor multilayer film reflector 102 is a semiconductor multilayer film reflector doped with n-type impurities, has little light absorption, and has high reflectance and conductivity. The semiconductor multilayer film reflector has a structure in which a plurality of types (for example, two types) of semiconductor layers (for example, AlGaAs layers) having different refractive indexes is alternately stacked with an optical thickness of 1/4 wavelength of an emission wavelength. Examples of the n-type impurities (dopants) include Si, Se, Ge, and the like.

### (Light Emitting Layer)

As an example, the light emitting layer 103 includes a compound semiconductor having band gap energy smaller than those of the first and second semiconductor structures SS1, SS2. The light emitting layer 103 includes, for example, a GaAs-based compound semiconductor (such as, for example, GaAs, AlGaAs, GaInAs and GaInAsN). The light emitting layer 103 may have a quantum well structure, a multiple quantum well structure, or a quantum dot structure. The light emitting layer 103 is also referred to as an "active layer". The light emitting layer 103 includes a light emitting region 103a that is a region (current injection region) into which a current is injected in the light emitting layer 103 and is a region that emits light.

### (Oxidation Confinement Layer)

The oxidation confinement layer 104 includes a non-oxidized region 104a that is a region corresponding to the light emitting region 103a and the oxidized region 104b as a current confinement region that surrounds the non-oxidized region 104a. The non-oxidized region 104a includes a compound semiconductor (such as, for example, AlGaAs and AlAs). The oxidized region 104b includes an insulator (for example, an oxide such as AlₓO_{y}). The oxidized region 104b has a higher resistance and a lower refractive index than those of the non-oxidized region 104a, and thus, the non-oxidized region 104a functions as a current/light passing region, and the oxidized region 104b functions as a current/light confinement region. In other words, the oxidized region 104b has both functions of a current confinement region and a light confinement region (light confinement region).

### (Second Semiconductor Multilayer Film Reflector)

As an example, the second semiconductor multilayer film reflector 105 is a semiconductor multilayer film reflector doped with p-type impurities, has little light absorption, and has high reflectance and conductivity. The semiconductor multilayer film reflector has a structure in which a plurality of types (for example, two types) of semiconductor layers (such as, for example, AlGaAs layers) having different refractive indexes is alternately stacked with an optical thickness of 1/4 wavelength of an emission wavelength. Examples of the p-type impurities (dopants) include, for example, Zn, Mg, Be, C, and the like. The second semiconductor multilayer film reflector 105 is set slightly higher in reflectance than the first semiconductor multilayer film reflector 102.

### (Anode Electrode)

The anode electrode 106 includes, for example, Au/Pt/Ti, or the like.

### (Cathode Electrode)

The cathode electrode 107 includes, for example, Au/Ni/AuGe, or the like.

### (Wiring, Convex Portion)

The wiring 108 includes, for example, Au, Ni, AuNi, AlTi, Cu, and the like.

The wiring 108 includes a first wiring portion 108a that covers a region around the light emitting element constituent portion LEC (for example, a region between the light emitting element constituent portion LEC and the dummy element constituent portion DEC) of one surface of the base portion BP (here, the upper surface 101a of the substrate 101), a second wiring portion 108b that is continuous with the first wiring portion 108a and covers a side surface of the proximity portion DEC1 of the dummy element constituent portion DEC on a side of the light emitting element constituent portion LEC, and a third wiring portion 108c that is continuous with the second wiring portion 108b and covers an upper surface of the proximity portion DEC1. As an example, the wiring 108 does not cover a portion other than the proximity portion DEC1 of the dummy element constituent portion DEC. Here, the thickness of the wiring 108 (particularly, the thickness of the third wiring portion 108c) is thinner than the thickness of the cathode electrode 107.

The third wiring portion 108c, which is a portion covering the upper surface (surface on the side opposite to the side of the base portion BP) of the proximity portion DEC1 of the wiring 108, includes at least a portion (for example, all) of the convex portion P. More specifically, at least a portion (for example, an end portion) of the third wiring portion 108c is located on an end portion of the cathode electrode 107 on the side of the proximity portion DEC1, and constitutes the convex portion P protruding to the side opposite to the side of the base portion BP more than the external connection surface 107a. Here, the convex portion P is a ridge extending in a direction orthogonal to the paper surface of Fig. 1 (in-plane direction orthogonal to a line 1-1 in Fig. 2). The ridge may be continuous as a whole or may include at least one intermittent portion (cut). Here, the ridge is linear in plan view, but may be curved in plan view, or may have a shape including a linear portion and a curved portion in plan view. A protruding amount pa of the convex portion P with respect to the external connection surface 107a (see Fig. 1) is preferably, for example, 0.5 µm to 5.0 µm. Here, the protruding amount pa is determined by the thickness of a portion of the third wiring portion 108c located on the cathode electrode 107. Note that the convex portion P can also be referred to as a "protrusion", a "protruding portion", or the like.

### (Light Source Device Including Surface Emitting Element)

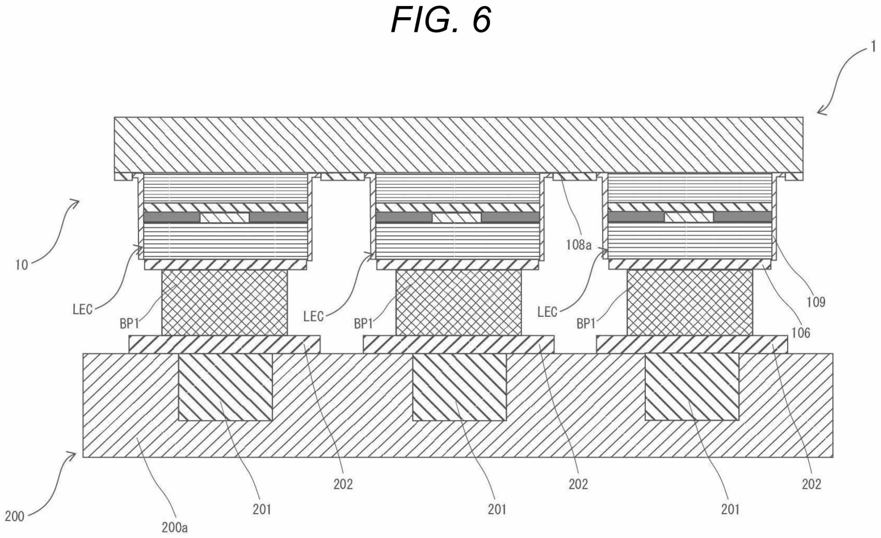

Fig. 5 is a cross-sectional view of a portion including the surface emitting element 10 of the light source device 1 including the surface emitting device SLD including the surface emitting element 10 according to Example 1 of one embodiment of the present technology. Fig. 6 is a cross-sectional view of a portion including a portion of the light emitting element constituent portion array LECA of the light source device 1 including the surface emitting device SLD including the surface emitting element 10 according to Example 1 of one embodiment of the present technology.

As illustrated in Figs. 5 and 6, the light source device 1 includes, as an example, the surface emitting device SLD and the other substrate 200.

The other substrate 200 may be a drive substrate including a drive circuit (driver) or a wiring substrate to be connected to the drive circuit (driver). As an example, the driver includes a power supply and a transistor that controls on/off of energization from the power supply to the surface emitting element 10.

As an example, the other substrate 200 includes a substrate portion 200a (such as, for example, a semiconductor substrate, a semi-insulating substrate and an insulating substrate), first and second wirings 201, 203, and first and second electrodes 202, 204. The first wiring 201 (for example, an anode wiring) is embedded in a recess provided at a position corresponding to the light emitting element constituent portion LEC on a surface of the substrate portion 200a on a side of the surface emitting element 10. The first electrode 202 is provided on a first wiring 201 and is electrically connected to the first wiring 201. A second wiring 203 (for example, a cathode wiring) is embedded in a recess provided at a position corresponding to the dummy element constituent portion DEC on a surface of the substrate portion 200a on a side of the surface emitting element 10. The second electrode 204 is provided on the second wiring 203 and is electrically connected to the second wiring 203.

The anode electrode 106 provided on each of the light emitting element constituent portions LEC and the corresponding first electrode 202 are bonded via the first bump BP1. The cathode electrode 107 provided on each of the dummy element constituent portions DEC and the corresponding second electrode 204 are bonded via the second bump BP2. The first and second bumps BP1, BP2 include, for example, Au, Ag, Cu, solder, and the like.

In the light source device 1, as a result of the convex portion P being provided in the proximity portion of the dummy element constituent portion DEC, protrusion of the second bump BP2 to the side of the light emitting element constituent portion LEC at the time of bump bonding is suppressed.

### <<Operation of Surface Emitting Element>>

Hereinafter, operation of the surface emitting element 10 will be described. If a power supply voltage of the driver is applied to the surface emitting element 10, a current from the anode side of the driver is injected into the light emitting region 103a of the light emitting layer 103 confined by the oxidation confinement layer 104 through the anode electrode 106 and the second semiconductor multilayer film reflector 105 in this order. In this event, the light emitting region 103a emits light, and the light travels between the first and second semiconductor multilayer film reflectors 102, 105 while being amplified by the light emitting layer 103 and confined by the oxidation confinement layer 104, and is emitted as laser light to a back surface of the substrate 101 when an oscillation condition is satisfied. The current injected into the light emitting region 103a flows out to the cathode side of the driver through the first semiconductor multilayer film reflector 102, the substrate 101, the wiring 108, and the cathode electrode 107 in this order.

### <<Method for Manufacturing Surface Emitting Device Including Surface Emitting Element>>

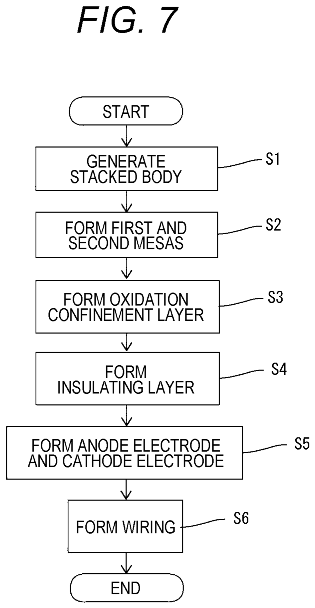

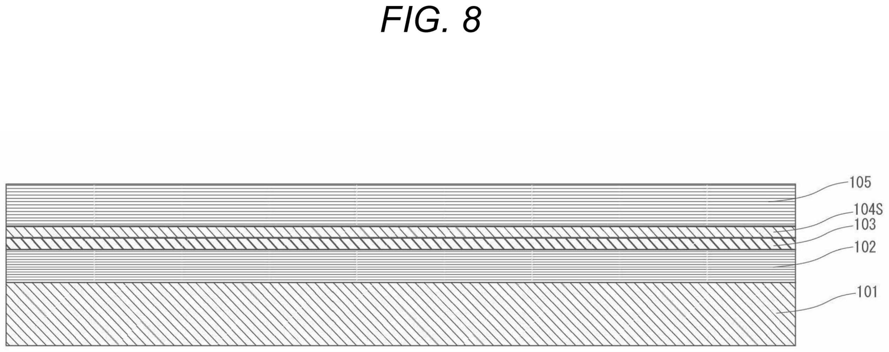

Hereinafter, an example of a method for manufacturing the surface emitting device SLD including the surface emitting element 10 will be described with reference to the flowchart of Fig. 7 and cross-sectional views (Figs. 8 to 14) corresponding to Fig. 1 for each manufacturing process of the surface emitting element 10. As overall flow, first, a plurality of surface emitting devices SLD each including the surface emitting element 10 is simultaneously generated on one wafer (hereinafter, referred to as the "substrate 101" for convenience) which is a base material of the substrate 101 by a semiconductor manufacturing method using a semiconductor manufacturing device. Next, the plurality of continuous integrated surface emitting devices SLD is separated from each other by dicing to obtain a chip-shaped surface emitting device SLD.

In the first step S1, a stacked body is generated (see Fig. 8). Specifically, for example, the first semiconductor multilayer film reflector 102, the light emitting layer 103, and the oxidized layer 104S (such as, for example, an AlGaAs layer and an AlAs layer), and the second semiconductor multilayer film reflector 105 are stacked in this order on the substrate 101 as a growth substrate by an epitaxial crystal growth method such as a metal organic chemical vapor deposition (MOCVD) method to generate a stacked body. In this event, as raw materials of the compound semiconductor, for example, a methylbased organometallic gas such as trimethylaluminum (TMAl), trimethylgallium (TMGa), or trimethylindium (TMIn) and an arsine (AsH₃) gas are used, as raw materials of donor impurities, for example, disilane (Si₂H₆) is used, and as raw materials of acceptor impurities, for example, carbon tetrabromide (CBr₄) is used.

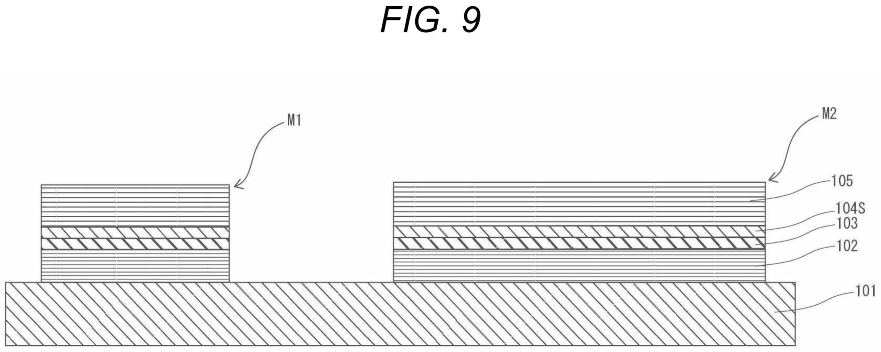

In the next step S2, the first and second mesas M1, M2 are formed (see Fig. 9). Specifically, a resist pattern covering a portion where the first and second mesas M1, M2 are to be formed is formed on the stacked body by photolithography, and the stacked body is etched by dry etching or wet etching using the resist pattern as a mask. The etching depth at this time is, for example, until the substrate 101 is exposed. As a result, the first and second mesas M1, M2 are formed. Thereafter, the resist pattern is removed.

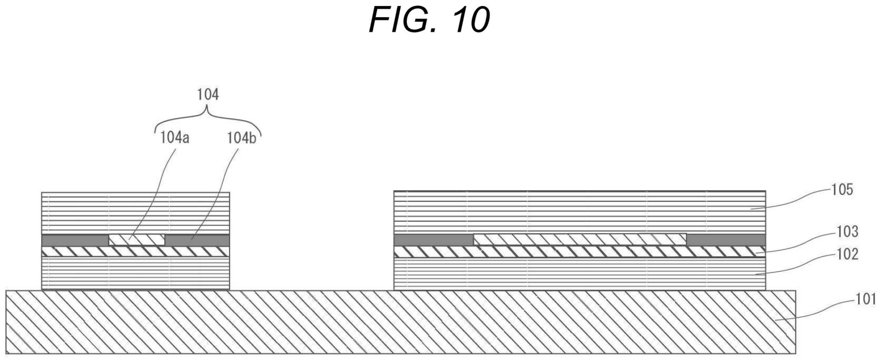

In the next step S3, the oxidation confinement layer 104 is formed (see Fig. 10). Specifically, the first and second mesas M1, M2 (see Fig. 9) are exposed to a high-temperature water vapor atmosphere, and the oxidized layer 104S is selectively oxidized by a predetermined distance from the side surface. As a result, the oxidation confinement layer 104 in which the non-oxidized region 104a is surrounded by the oxidized region 104b is formed in the first mesa M1, and thereby, the light emitting mesa is generated. A layer in which the non-oxidized region is surrounded by the oxidized region is also formed in the second mesa M2, and thereby, the dummy mesa is generated.

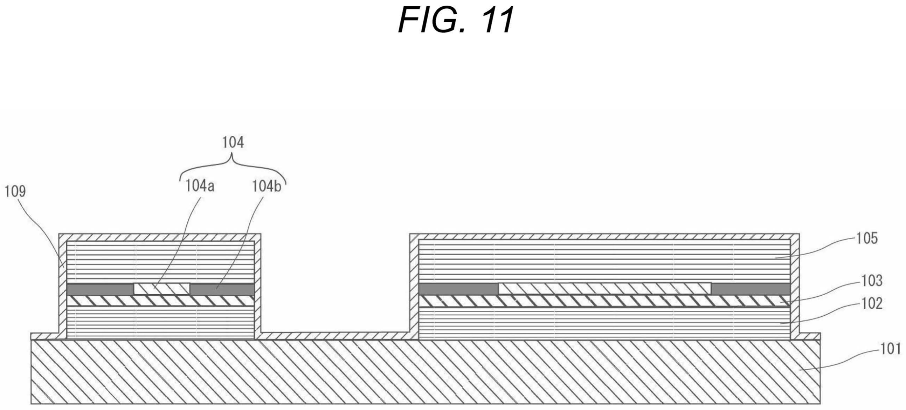

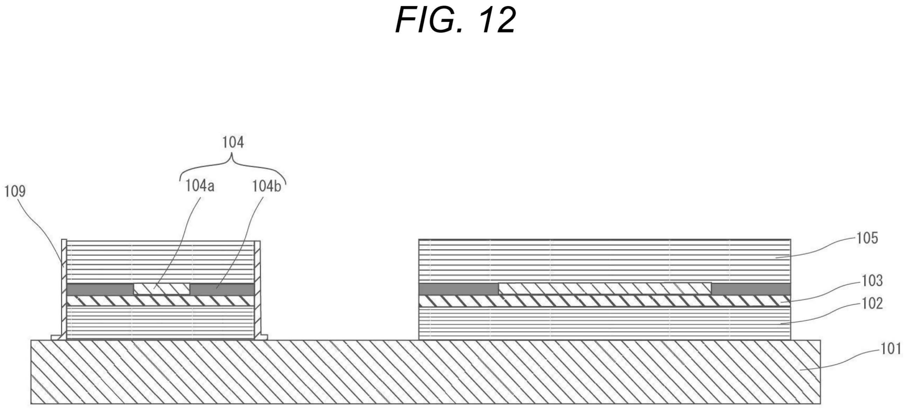

In the next step S4, the insulating film 109 is formed. Specifically, first, the insulating film 109 is formed on the entire surface (see Fig. 11). Next, the insulating film 109 other than the insulating film 109 covering the side surface of the light emitting mesa is removed by photolithography and etching to expose the top of the light emitting mesa, the top and side surfaces of the dummy mesa, and the region of the upper surface of the substrate 101 around the light emitting mesa and the dummy mesa (see Fig. 12).

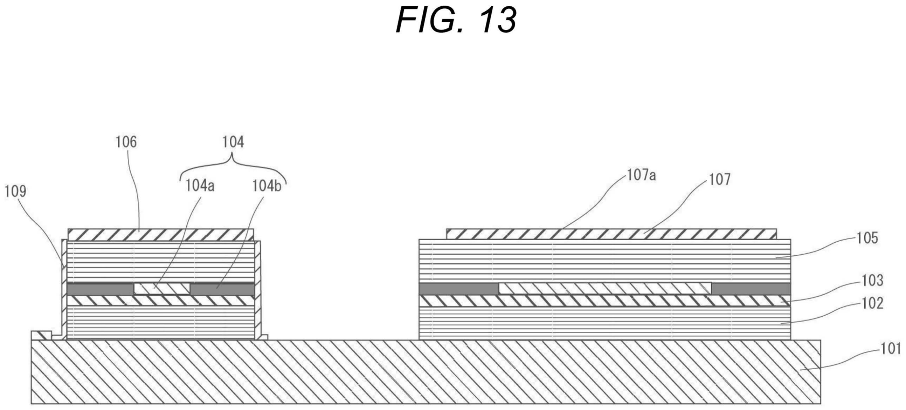

In the next step S5, the anode electrode 106 and the cathode electrode 107 are formed (see Fig. 13). Specifically, for example, by a lift-off method, the anode electrode 106 is formed in a solid shape on the top of the light emitting mesa, and the cathode electrode 107 is formed in a solid shape on the top of the dummy mesa. In this event, for example, vapor deposition, sputtering, or the like, is used for forming an electrode material.

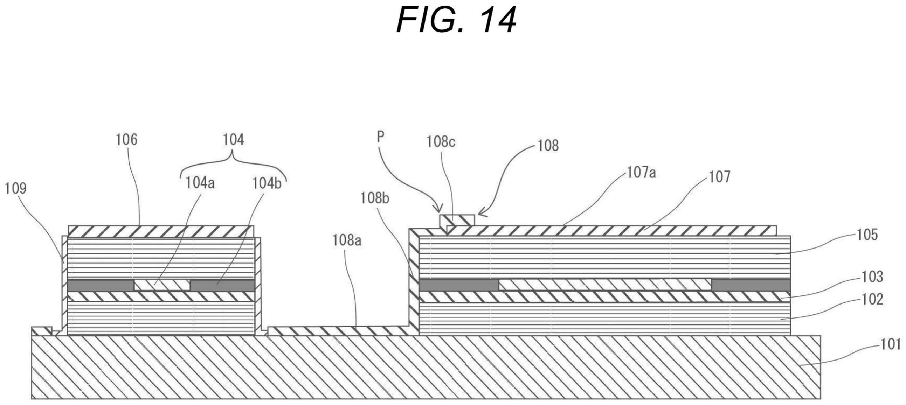

In the last step S6, the wiring 108 is formed (see Fig. 14). Specifically, for example, by the lift-off method, the wiring 108 is formed such that the first wiring portion 108a covers the upper surface of the substrate 101, the second wiring portion 108b covers the side surface on the side of the light emitting mesa of the proximity portion of the dummy mesa, and an end portion of the third wiring portion 108c is located on an end portion of the cathode electrode 107. In this event, for example, vapor deposition, sputtering, or the like, is used for forming an electrode material.

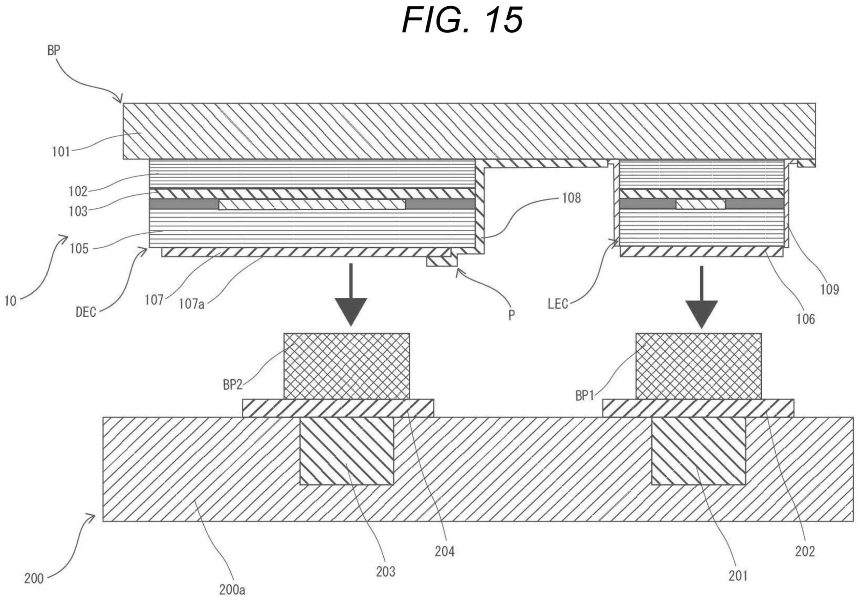

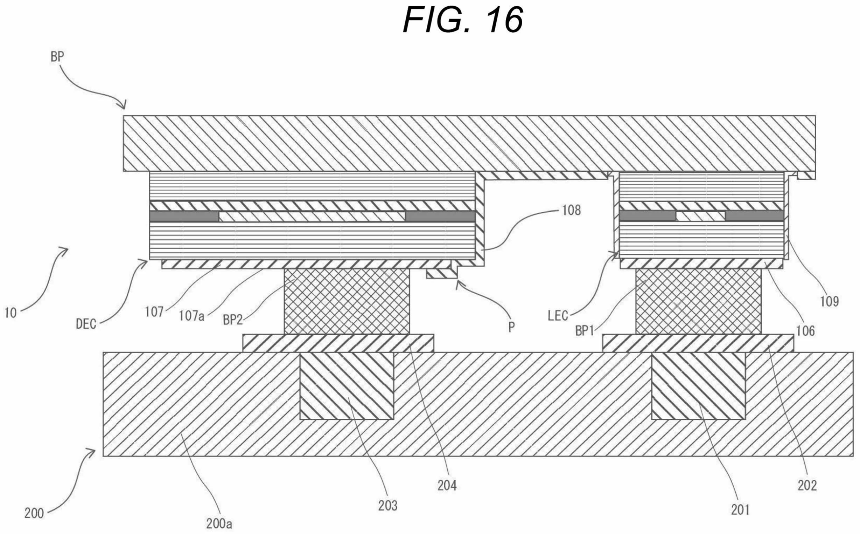

As illustrated in Figs. 15 and 16, the surface emitting device SLD manufactured as described above is bonded to the other substrate 200 via the first and second bumps BP1 and BP2 (junction-down mounted). In this event, even if the second bump BP2 is crushed due to the overload, the convex portion P serves as a stopper, so that the second bump BP2 is suppressed from protruding to the side of the light emitting element constituent portion LEC. Thus, the convex portion P can also be referred to as a "bump stopper".

### <<Effects of Surface Emitting Element>>

Hereinafter, effects of the surface emitting element 10 will be described.

The surface emitting element 10 includes the base portion BP including the substrate 101, and the light emitting element constituent portion LEC and the dummy element constituent portion DEC provided on one surface (for example, the upper surface 101a of the substrate 101) of the base portion BP so as to be spaced apart in the in-plane direction. The cathode electrode 107 including the external connection surface 107a is provided on the dummy element constituent portion DEC. The convex portion P protruding to the side opposite to the side of the base portion BP more than the external connection surface 107a is provided in the proximity portion DEC1 relatively close to the light emitting element constituent portion LEC, of the dummy element constituent portion DEC.

As a result, in a case where the cathode electrode 107 provided on the dummy element constituent portion DEC is connected to the other substrate 200 via the second bump BP2, it is possible to suppress protrusion of the second bump BP2 to the side of the light emitting element constituent portion LEC. This results in making it possible to suppress erosion of the light emitting element constituent portion LEC and improve reliability.

The external connection surface 107a is a flat surface. As a result, an area of the bump joint surface to be bump-bonded to the other substrate 200 can be secured.

The wiring 108 covering a portion of the one surface of the base portion BP (for example, a region around the light emitting element constituent portion LEC) and the proximity portion DEC1 is provided. The wiring 108 does not cover a portion including the remote portion DEC2 other than the proximity portion DEC1. As a result, the base portion BP and the cathode electrode 107 can be electrically connected to each other, and the following effects can be expected.
- Internal stress applied to the dummy element constituent portion DEC can be reduced, and occurrence of cracks can be suppressed.
- Stress applied at the time of bonding can be released to the side of the remote portion DEC2, warpage of the element can be reduced, and a degree of freedom in installation of the bump can be improved.
- Destruction of the second semiconductor structure SS2 (for example, the second semiconductor multilayer film reflector 105) in ohmic contact with the cathode electrode 107 due to force acting at the time of bonding can be suppressed.

A portion covering the proximity portion DEC1, of the wiring 108 includes at least a portion (for example, all) of the convex portion P. It is therefore not necessary to separately provide a dedicated member for constituting the convex portion P.

The external connection surface 107a is continuously provided from the proximity portion DEC1 to the remote portion DEC2 relatively far from the light emitting element constituent portion LEC, of the dummy element constituent portion DEC. As a result, an area of the bump joint surface to be bump-bonded to the other substrate 200 can be sufficiently secured.

It is preferable that the anode electrode 107 is provided on the light emitting element constituent portion LEC, and the cathode electrode 107 and the anode electrode 106 have the same surface height on the side opposite to the side of the base portion BP. As a result, a bonding load can be uniformly applied to the light emitting element constituent portion LEC and the dummy element constituent portion DEC, and a bonding failure and breakage of each constituent portion can be suppressed.

Both the light emitting element constituent portion LEC and the dummy element constituent portion DEC have a mesa shape. As a result, the light emitting element constituent portion LEC and the dummy element constituent portion DEC can be spatially separated, and the oxidation confinement layer 104 can be easily formed.

Each of the light emitting element constituent portion LEC and the dummy element constituent portion DEC includes at least a portion of the first semiconductor structure SS1 arranged on the substrate 101, the light emitting layer 103 arranged on the first semiconductor structure SS1, and the second semiconductor structure SS2 arranged on the light emitting layer 103. As a result, the light emitting element constituent portion LEC and the dummy element constituent portion DEC can be efficiently generated.

The light emitting element constituent portion LEC includes the oxidation confinement layer 104 including a current confinement region arranged between the surface (upper surface) of the second semiconductor structure SS2 on the side opposite to the side of the light emitting layer 103 and the light emitting layer 103. By this means, a light confinement function in addition to the current confinement function can be obtained.

Each of the first and second semiconductor structures SS1, SS2 has a semiconductor multilayer film reflector. By this means, conductivity and high reflectance can be obtained.

The surface emitting element 10 emits light to a side opposite to the side of the light emitting element constituent portion LEC, of the base portion BP. This makes it possible to provide a backside emission type surface emitting element.

The surface emitting element 10 includes at least a plurality of light emitting element constituent portions LEC out of the light emitting element constituent portion LEC and the dummy element constituent portion DEC, and the wiring 108 is a common wiring common to at least two light emitting element constituent portions LEC. This can simplify an electrode formation process.

The light source device 1 includes the surface emitting element 10 and the other substrate 200, the anode electrode 106 is provided on the light emitting element constituent portion LEC, and the anode electrode 106 and the other substrate 200 are bonded via the first bump BP1, and the cathode electrode 107 and the other substrate 200 are bonded via the second bump BP2. Accordingly, a light source device having excellent reliability can be provided.

### <2. Surface Emitting Element According to Example 2 of One Embodiment of Present Technology>

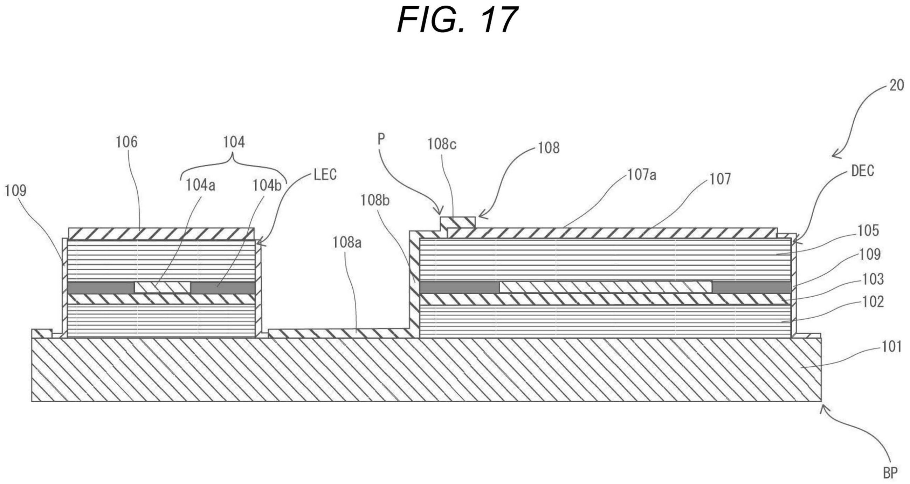

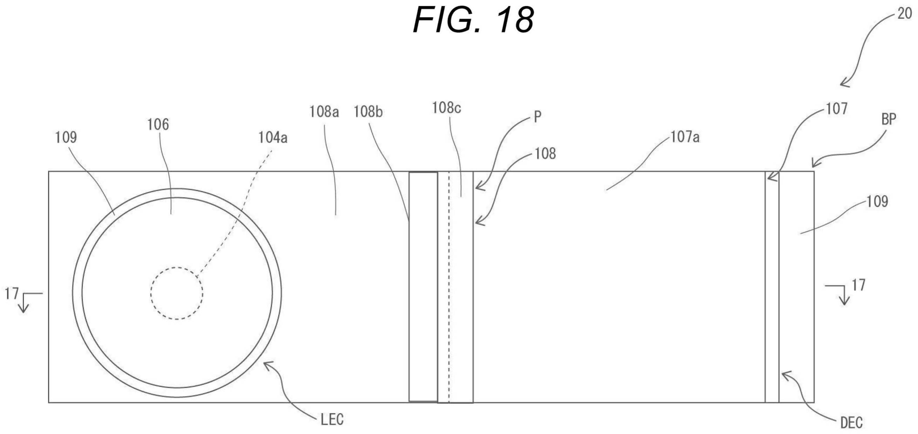

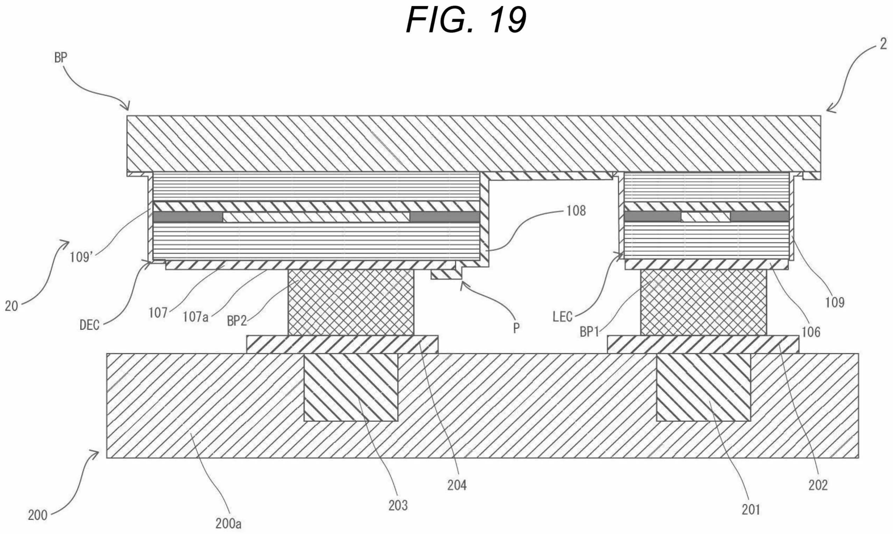

Fig. 17 is a cross-sectional view of a surface emitting element 20 according to Example 2 of one embodiment of the present technology. Fig. 18 is a plan view of the surface emitting element 20 according to Example 2 of one embodiment of the present technology. Fig. 17 is a cross-sectional view taken along a line 17-17 in Fig. 18. Fig. 19 is a cross-sectional view of a portion including the surface emitting element 20 of the light source device 2 including the surface emitting device SLD including the surface emitting element 20 according to Example 2 of one embodiment of the present technology.

As illustrated in Figs. 17 and 18, the surface emitting element 20 has a configuration similar to that of the surface emitting element 10 according to Example 1 except that at least the remote portion DEC2 is covered with the insulating film 109 as a protective film.

In the surface emitting element 20, as an example, the top and side surfaces of the remote portion DEC2 and a region around the remote portion DEC2 on the upper surface of the substrate 101 are covered with the insulating film 109.

The surface emitting element 20 can be manufactured by a manufacturing method similar to the method for manufacturing the surface emitting element 10 according to Example 1 except that when a portion of the insulating film 109 (see Fig. 11) formed on the entire surface is removed, the insulating film 109 covering at least the remote portion DEC2 is left together with the insulating film 109 covering the side surface of the light emitting element constituent portion LEC.

As illustrated in Fig. 19, similarly to the surface emitting element 10 according to Example 1, the surface emitting element 20 is also junction-down mounted on the other substrate 200, and can constitute the light source device 2 together with the other substrate 200.

According to the surface emitting element 20, effects similar to those of the surface emitting element 10 are obtained, and the dummy element constituent portion DEC can be protected by the insulating film 109, and reliability can be improved.

### <3. Surface Emitting Element According to Example 3 of One Embodiment of Present Technology>

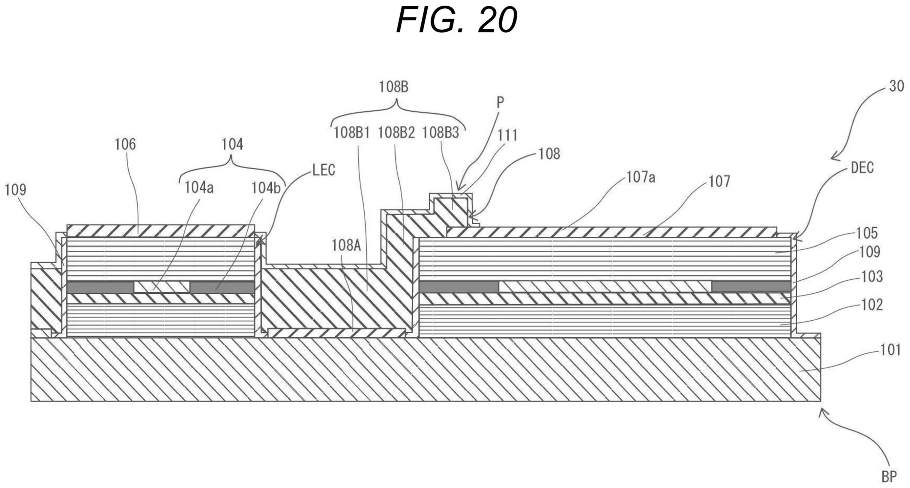

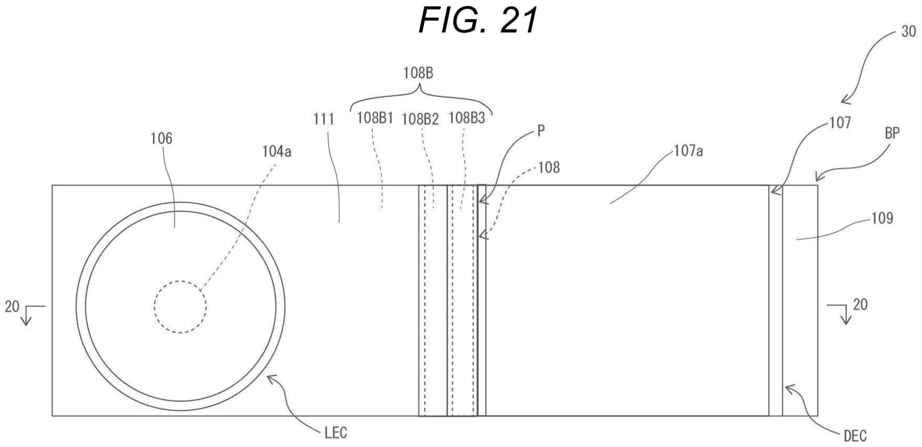

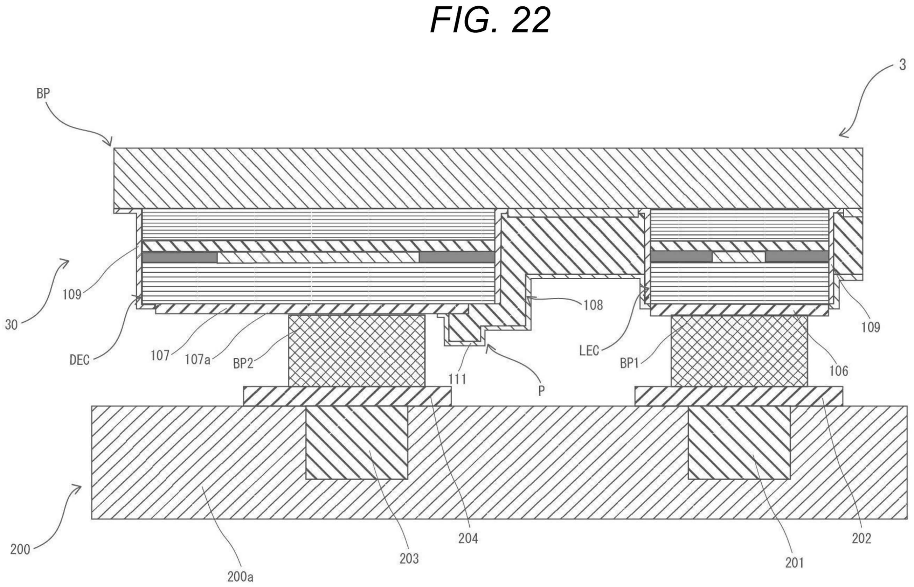

Fig. 20 is a cross-sectional view of a surface emitting element 30 according to Example 3 of one embodiment of the present technology. Fig. 21 is a plan view of the surface emitting element 30 according to Example 3 of one embodiment of the present technology. Fig. 20 is a cross-sectional view taken along a line 20-20 in Fig. 21. Fig. 22 is a cross-sectional view of a portion including the surface emitting element 30 of the light source device 3 including the surface emitting device SLD including the surface emitting element 30 according to Example 3 of one embodiment of the present technology.

As illustrated in Figs. 20 and 21, the surface emitting element 30 has a configuration similar to that of the surface emitting element 20 according to Example 2 except that the wiring 108 includes first and second wirings 108A, 108B, and the wiring 108 is covered with an insulating film 111 as a protective film, and the convex portion P includes a portion of the insulating film 111.

In the surface emitting element 30, the wiring 108 includes the first wiring 108A provided in a solid state on a region around the light emitting element constituent portion LEC (for example, a region between the light emitting element constituent portion LEC and the dummy element constituent portion DEC) on one surface of the base portion BP (for example, the upper surface of the substrate 101), and the second wiring 108B provided on the first wiring 108A.

The first wiring 108A includes, for example, Au/Ni/AuGe, or the like. The second wiring 108B includes conductive plating. The conductive plating includes, for example, Au, Ag, Cu, or the like.

As an example, the second wiring 108B includes a bottom portion 108B1 provided on the first wiring 108A, a rising portion 108B2 rising from the bottom portion 108B1 along the proximity portion of the dummy element constituent portion DEC, and a projecting portion 108B3 projecting from the rising portion 108B2 onto the proximity portion. Note that the rising portion 108B2 can be omitted.

A tip portion of the projecting portion 108B3 is located on the cathode electrode 107 and constitutes a portion of the convex portion P. The insulating film 111 provided on the tip portion of the projecting portion 108B3 constitutes the other portion of the convex portion P.

The surface emitting element 30 can be manufactured by a manufacturing method similar to the method for manufacturing the surface emitting element 20 according to Example 2 except that the first wiring 108A is formed on the substrate 101 by, for example, lift-off, then the second wiring 108B is formed using, for example, a plating method, and the insulating film 111 is formed on the second wiring 108B. Note that in a case where the plating method is used, it is preferable to form a seed layer at a place where the second wiring 108B is to be formed in advance.

As illustrated in Fig. 22, similarly to the surface emitting element 10 according to Example 1, the surface emitting element 30 is also junction-down mounted on the other substrate 200, and the light source device 3 can be constituted together with the other substrate 200.

According to the surface emitting element 30, the first wiring 108A in ohmic contact with the substrate 101 is protected by the second wiring 108B, and the second wiring 108B is protected by the insulating film 111. Furthermore, a thickness of the wiring 108 can be increased, so that resistance can be reduced.

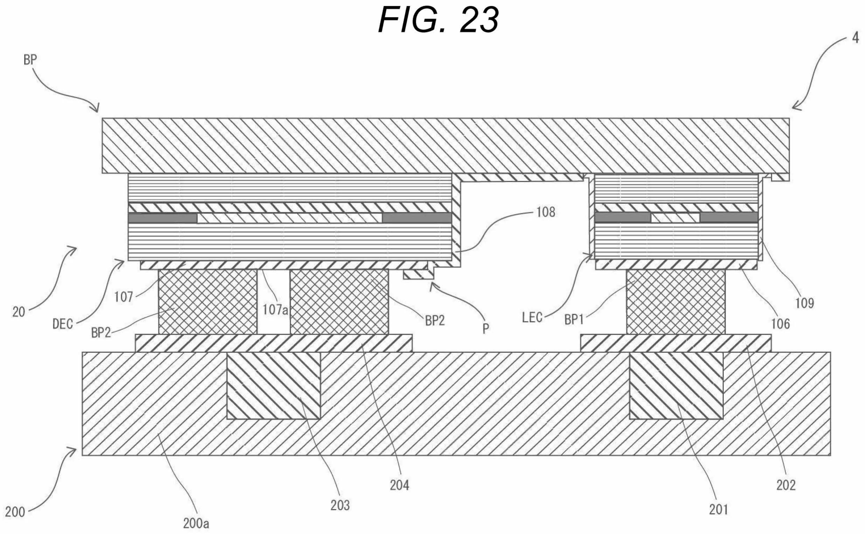

Fig. 23 is a cross-sectional view of a portion including the surface emitting element 10 of the light source device 4 including the surface emitting device SLD including the surface emitting element 10 according to Example 1 of one embodiment of the present technology.

In the light source device 4, the cathode electrode 107 provided on the dummy element constituent portion DEC and the second electrode 204 of the other substrate 200 are bonded via a plurality of (for example, two) second bumps BP2. The external connection surface 107a of the dummy element constituent portion DEC is a flat surface having a relatively large area, so that it is possible to perform bonding using such a plurality of bumps and perform more stable bonding. Also in this case, protrusion of the second bump BP2 to the side of the light emitting element constituent portion LEC is effectively suppressed by the convex portion P.

### <4. Surface Emitting Element According to Example 4 of One Embodiment of Present Technology>

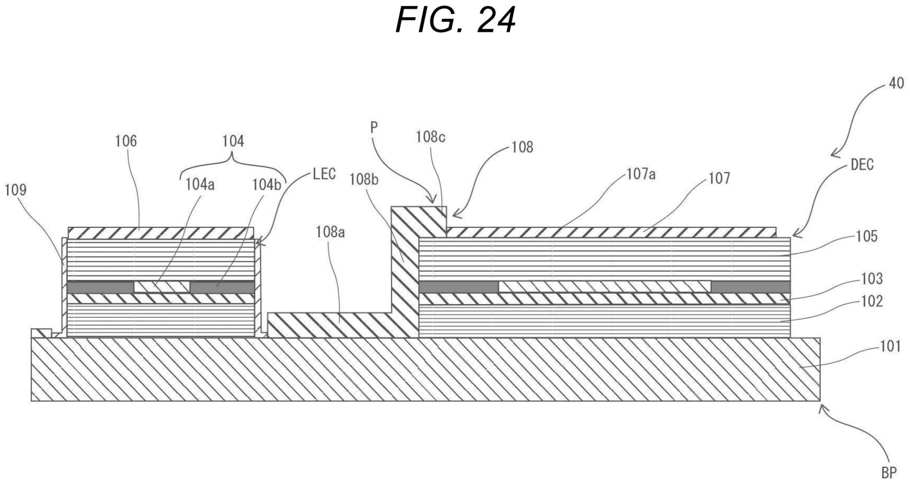

Fig. 24 is a cross-sectional view of a surface emitting element 40 according to Example 4 of one embodiment of the present technology.

As illustrated in Fig. 24, the surface emitting element 40 according to Example 4 has a configuration similar to that of the surface emitting element 10 according to Example 1 except that the third wiring portion 108c of the wiring 108 does not include a portion located on the cathode electrode 107, and the thickness of the third wiring portion 108c is thicker than the thickness of the cathode electrode 107.

In the surface emitting element 40, the third wiring portion 108c of the wiring 108 includes the convex portion P. The third wiring portion 108c is in contact with the cathode electrode 107. Note that at least a portion of the third wiring portion 108c may be located on the cathode electrode 107. The wiring 108 includes, for example, conductive plating (such as, for example, Au plating, Ag plating, and Cu plating).

According to the surface emitting element 40, the wiring 108 is made thick, so that resistance can be reduced.

### <5. Surface Emitting Element According to Example 5 of One Embodiment of Present Technology>

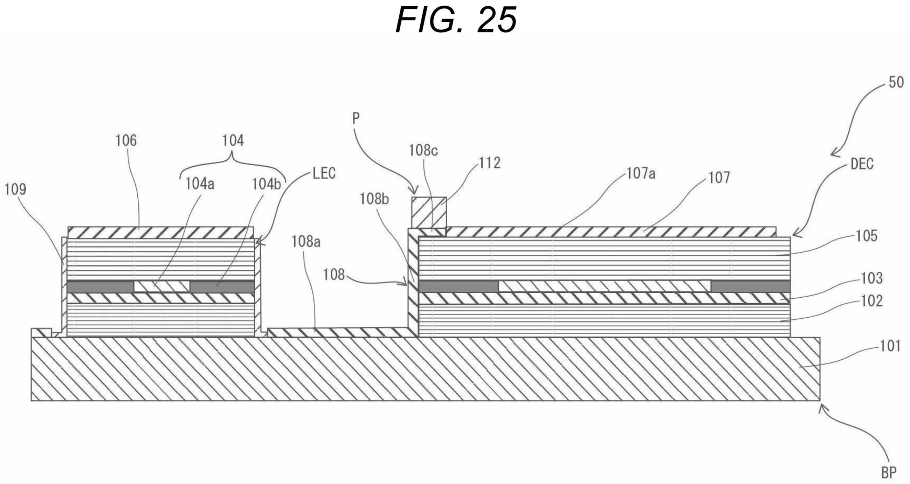

Fig. 25 is a cross-sectional view of a surface emitting element 50 according to Example 5 of one embodiment of the present technology.

As illustrated in Fig. 25, the surface emitting element 50 according to Example 5 has a configuration similar to that of the surface emitting element 10 according to Example 1 except that the third wiring portion 108c of the wiring 108 does not include a portion located on the cathode electrode 107, and the other member 112 different from the wiring 108 includes at least a portion of the convex portion P.

The other member 112 is, for example, a ridge member provided on the third wiring portion 108c of the wiring 108. As an example, the other member 112 includes a conductor (for example, a metal such as Au, Ag, Cu, Al, W, or Ni). The other member 112 may include an insulator (such as, for example, SiO₂, SiN, and SiON). Here, the third wiring portion 108c and the cathode electrode 107 are in contact with each other.

According to the surface emitting element 50, the other member 112 including at least a portion of the convex portion P is provided on the third wiring portion 108c, and thus, even in a case where the thickness of the wiring 108 (specifically, the thickness of the third wiring portion 108c) is thin, a protruding amount of the convex portion P can be set to a desired protruding amount by adjusting the thickness of the other member 112. Note that the convex portion P may have a portion (upper portion) of the third wiring portion 108c in addition to the other member 112.

### <6. Surface Emitting Element According to Example 6 of One Embodiment of Present Technology>

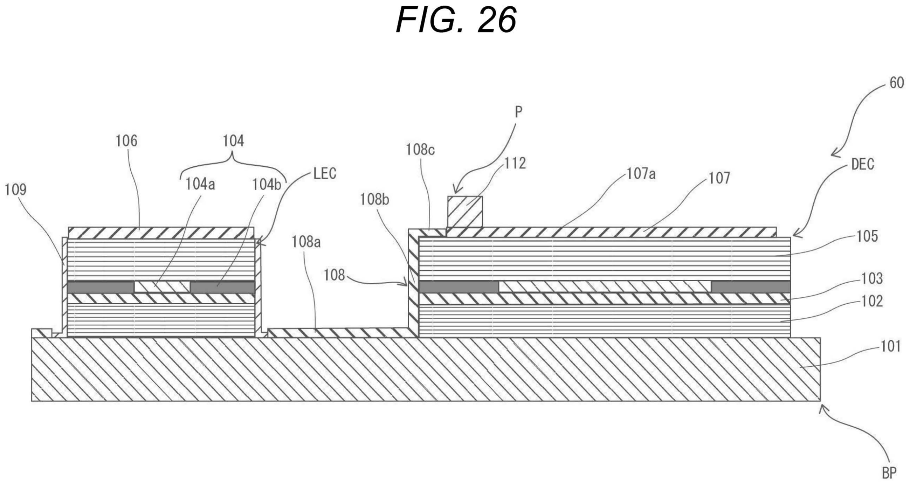

Fig. 26 is a cross-sectional view of a surface emitting element 60 according to Example 6 of one embodiment of the present technology.

As illustrated in Fig. 26, the surface emitting element 60 according to Example 6 has a configuration similar to that of the surface emitting element 50 according to Example 5 except that the convex portion P includes the other member 112 different from the wiring 108 on the cathode electrode 107.

The other member 112 is, for example, a ridge member provided on an end portion of the cathode electrode 107 on the side of the light emitting element constituent portion LEC. As an example, the other member 112 includes a conductor (for example, a metal such as Au, Ag, Cu, Al, W, or Ni). The other member 112 may include an insulator (such as, for example, SiO₂, SiN, and SiON). Here, the third wiring portion 108c and the cathode electrode 107 are in contact with each other.

According to the surface emitting element 60, the convex portion P includes the other member 112 different from the wiring 108 on the cathode electrode 107, and thus, the protruding amount of the convex portion P can be set to a desired protruding amount by the thickness of the other member 112 regardless of the thickness of the wiring 108 (specifically, the thickness of the third wiring portion 108c).

### <7. Surface Emitting Element According to Example 7 of One Embodiment of Present Technology>

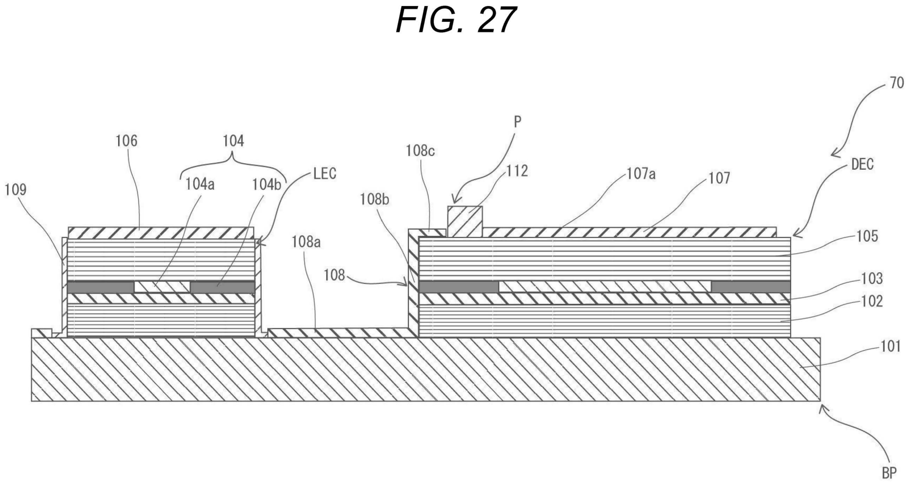

Fig. 27 is a cross-sectional view of a surface emitting element 70 according to Example 7 of one embodiment of the present technology.

As illustrated in Fig. 27, the surface emitting element 70 according to Example 7 has a configuration similar to that of the surface emitting element 50 according to Example 5 except that the convex portion P includes the other member 112 different from the wiring 108 on the dummy element constituent portion DEC.

As an example, the other member 112 is a ridge member provided on a portion between the third wiring portion 108c of the wiring 108 and the cathode electrode 107 on the upper surface of the second semiconductor multilayer film reflector 105. The thickness of the other member 112 is thicker than the thickness of the cathode electrode 107. As an example, the other member 112 includes a conductor (for example, a metal such as Au, Ag, Cu, Al, W, or Ni). The other member 112 may include an insulator (such as, for example, SiO₂, SiN, and SiON). Here, the other member 112 is in contact with the third wiring portion 108c and the cathode electrode 107.

According to the surface emitting element 70, the convex portion P includes the other member 112 different from the wiring 108 on the dummy element constituting portion DEC, and thus, the protruding amount of the convex portion P can be set to a desired protruding amount by the thickness of the other member 112 regardless of the thickness of the wiring 108 (specifically, the thickness of the third wiring portion 108c).

### <8. Surface Emitting Element According to Example 8 of One Embodiment of Present Technology>

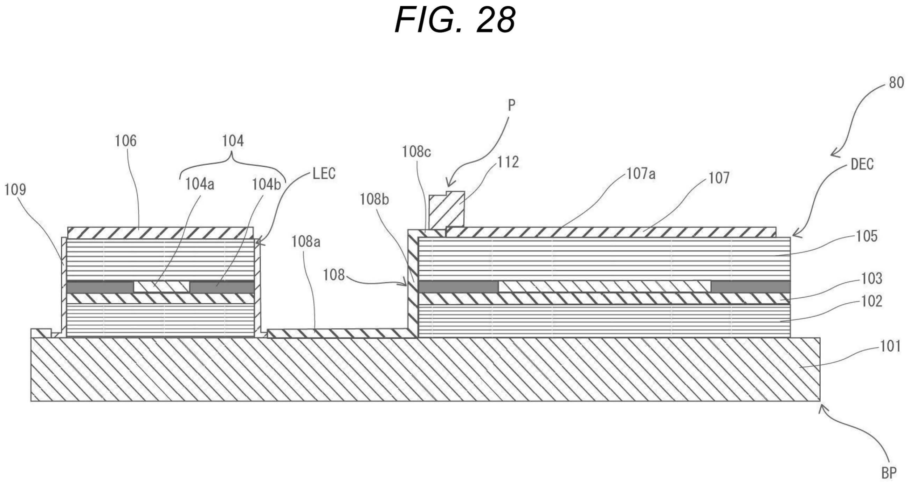

Fig. 28 is a cross-sectional view of a surface emitting element 80 according to Example 8 of one embodiment of the present technology.

As illustrated in Fig. 28, the surface emitting element 80 according to Example 8 has a configuration similar to that of the surface emitting element 50 according to Example 5 except that the other member 112 (for example, a ridge member) included in the convex portion P is provided over the third wiring portion 108c of the wiring 108 and the cathode electrode 107.

As an example, the other member 112 includes a conductor (for example, a metal such as Au, Ag, Cu, Al, W, or Ni). The other member 112 may include an insulator (such as, for example, SiO₂, SiN, and SiON).

According to the surface emitting element 80, the other member 112 of the convex portion P is provided across the third wiring portion 108c of the wiring 108 and the cathode electrode 107, and thus, the protruding amount of the convex portion P can be set to a desired protruding amount by the thickness of the other member 112 regardless of the thickness of the wiring 108 (specifically, the thickness of the third wiring portion 108c), and the conductivity between the wiring 108 and the cathode electrode 107 can be further enhanced.

### <9. Surface Emitting Element According to Example 9 of One Embodiment of Present Technology>

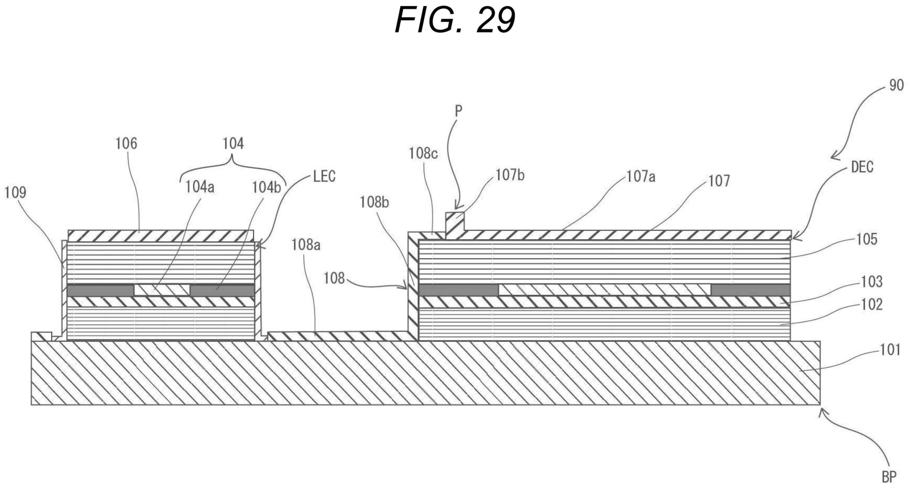

Fig. 29 is a cross-sectional view of a surface emitting element 90 according to Example 9 of one embodiment of the present technology.

As illustrated in Fig. 29, the surface emitting element 90 according to Example 9 has a configuration similar to that of the surface emitting element 10 according to Example 1 except that the third wiring portion 108c of the wiring 108 does not include a portion located on the cathode electrode 107, and the cathode electrode 107 includes at least a portion (for example, all) of the convex portion P. The cathode electrode 107 includes a ridge 107b constituting the convex portion P. Note that a conductor (for example, a metal such as Au, Ag, Cu, Al, W, or Ni) or an insulator (such as, for example, SiO₂, SiN, and SiON) may be provided on at least the ridge 107b. Here, the third wiring portion 108c and the cathode electrode 107 are in contact with each other.

The surface emitting element 90 can be manufactured by a manufacturing method substantially similar to the method for manufacturing the surface emitting element 10 according to Example 1 except that the cathode electrode 107 including at least a portion of the convex portion P is formed by performing the lift-off method a plurality of times (for example, twice) or by forming a film of an electrode material using the lift-off method and etching the electrode material.

According to the surface emitting element 80, the cathode electrode 107 includes at least a portion of the convex portion P, and thus, the protruding amount of the convex portion P can be set to a desired protruding amount by at least the cross-sectional shape of the cathode electrode 107.

### <10. Surface Emitting Element According to Example 10 of One Embodiment of Present Technology>

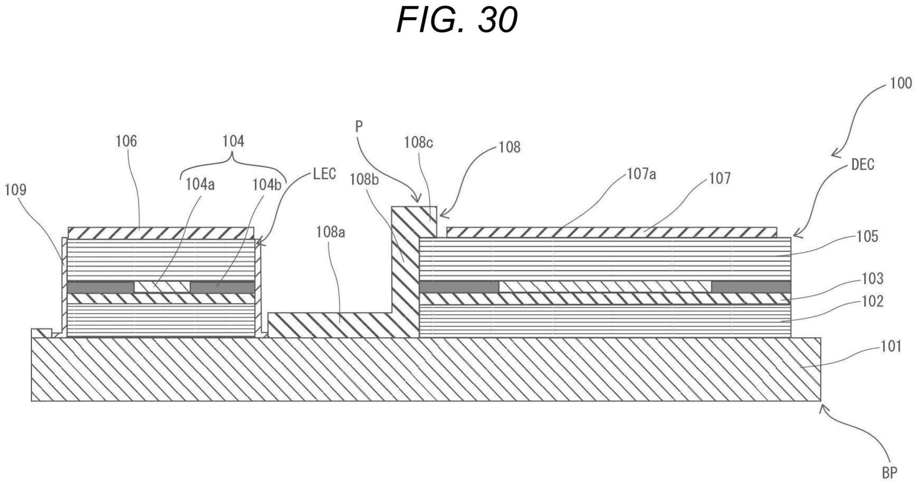

Fig. 30 is a cross-sectional view of a surface emitting element 100 according to Example 10 of one embodiment of the present technology.

As illustrated in Fig. 30, the surface emitting element 100 according to Example 10 has a configuration similar to that of the surface emitting element 40 according to Example 4 except that the third wiring portion 108c of the wiring 108 is not in contact with the cathode electrode 107.

In the surface emitting element 80, there is a gap between the third wiring portion 108c and the cathode electrode 107.

The surface emitting element 80 can be manufactured by a manufacturing method similar to the method for manufacturing the surface emitting element 40 according to Example 4 except that a gap is formed between the third wiring portion 108c and the cathode electrode 107.

In the surface emitting element 80, the third wiring portion 108c of the wiring 108 is not in contact with the cathode electrode 107, but the conductivity between the third wiring portion 108c and the cathode electrode 107 can be secured via the second semiconductor multilayer film reflector 105.

### <11. Surface Emitting Element According to Example 11 of One Embodiment of Present Technology>

### <<Configuration of Surface Emitting Element>>

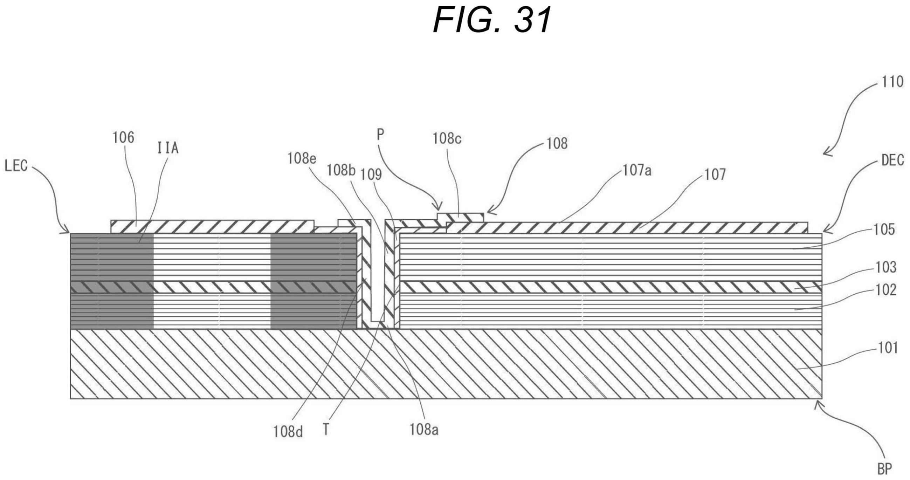

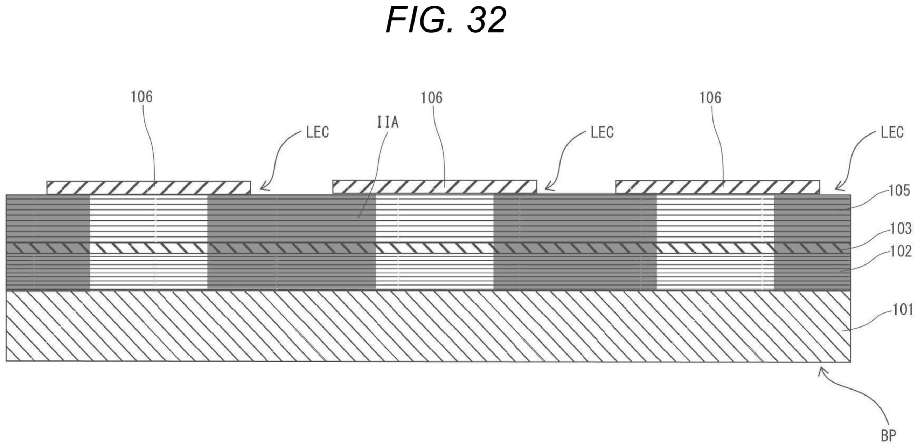

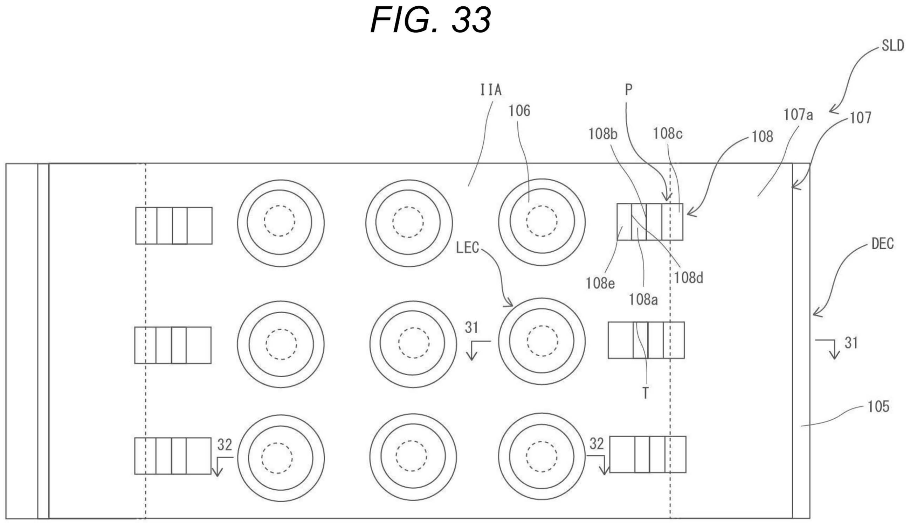

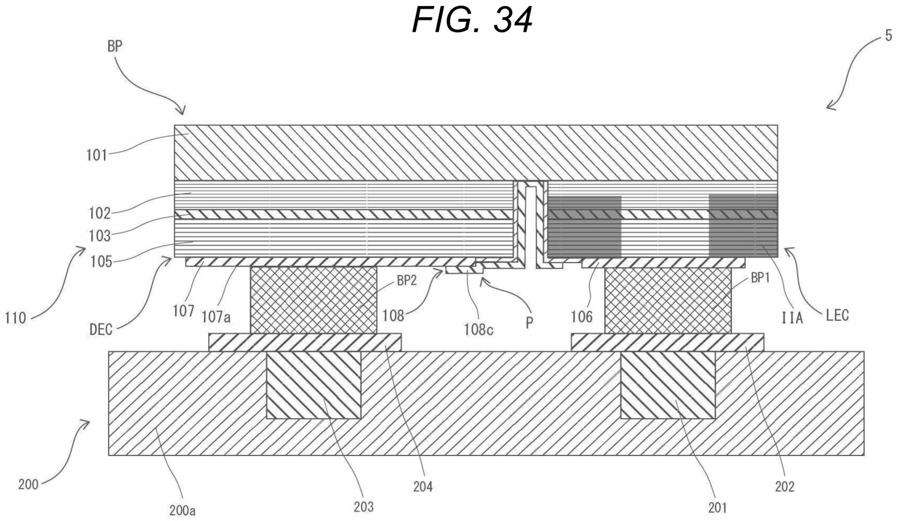

Fig. 31 is a cross-sectional view of a surface emitting element 110 according to Example 11 of one embodiment of the present technology. Fig. 32 is a cross-sectional view of a portion of a light emitting element constituent portion array of a surface emitting device SLD including the surface emitting element 110 according to Example 11 of one embodiment of the present technology. Fig. 33 is a plan view of the surface emitting device SLD including the surface emitting element 110 according to Example 11 of one embodiment of the present technology. Fig. 34 is a cross-sectional view of a portion including a portion of the surface emitting element 110 of the light source device 5 including the surface emitting device SLD including the surface emitting element 110 according to Example 11 of one embodiment of the present technology. Fig. 31 is a cross-sectional view taken along a line 31-31 in Fig. 33. Fig. 32 is a cross-sectional view taken along a line 32-32 in Fig. 33.

As illustrated in Figs. 31 to 33, the surface emitting element 110 has a configuration substantially similar to that of the surface emitting element 10 according to Example 1 except that both the light emitting element constituent portion LEC and the dummy element constituent portion DEC do not have a mesa shape (have a mesa-less structure) and an ion implantation region IIA is provided instead of the oxidation confinement layer 104.

In the surface emitting element 110, as an example, the light emitting element constituent portion LEC includes the first semiconductor multilayer film reflector 102, the light emitting layer 103, and the second semiconductor multilayer film reflector 105. The base portion BP includes the substrate 101.

The ion implantation region IIA as a current confinement region is provided so as to surround a region immediately below the central portion of the anode electrode 106 of the light emitting element constituent portion LEC. Here, the ion implantation region IIA is provided in the entire region in a stacking direction (vertical direction) of the light emitting element constituent portion LEC. Also in the surface emitting element 110, a lateral current path is formed in the substrate 101.

Examples of the ion species to be used for the ion implantation region IIA include such as H⁺ and B⁺, for example.

A trench T is provided between the light emitting element constituent portion LEC and the dummy element constituent portion DEC. Here, a bottom surface of the trench T coincides with the upper surface of the substrate 101. One of one side surface and the other side surface facing each other of the trench T is a side surface of the light emitting element constituent portion LEC, and the other is a side surface of the dummy element constituent portion DEC. The trench means a "groove" in a narrow sense, but includes a "hole", a "concave portion", a "recess", and the like, in a broad sense.

The side surface of the trench T and a region around an opening end are covered with the insulating film 109.

The wiring 108 includes first to fifth wiring portions 108a, 108b, 108c, 108d, 108e. The first wiring portion 108a is provided on the bottom surface of the trench T. The second wiring portion 108b is provided along the insulating film 109 covering the side surface of the trench T on a side of the dummy element constituent portion DEC. The third wiring portion 108c is provided on the insulating film 109 covering the upper surface of the proximity portion of the dummy element constituent portion DEC, and on the cathode electrode 107. The fourth wiring portion 108d is provided along the insulating film 109 covering the side surface of the trench T on a side of the light emitting element constituent portion LEC. The fifth wiring portion 108e is provided on the insulating film 109 covering the upper surface of the light emitting element constituent portion LEC. The wiring 108 configured as described above ensures favorable conductivity between the substrate 101 and the cathode electrode 107.

As illustrated in Fig. 34, similarly to the surface emitting element 10 according to Example 1, the surface emitting element 110 is also junction-down mounted on the other substrate 200, and the light source device 5 can be constituted together with the other substrate 200.

### <<Method for Manufacturing Surface Emitting Device Including Surface Emitting Element>>

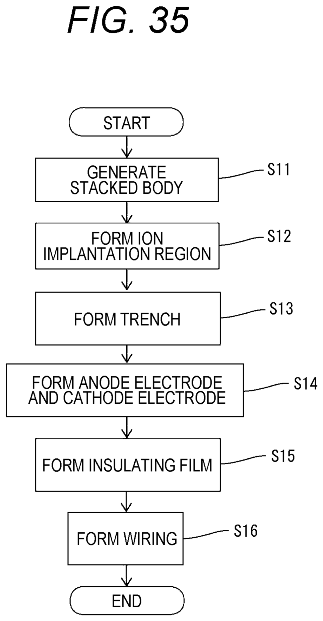

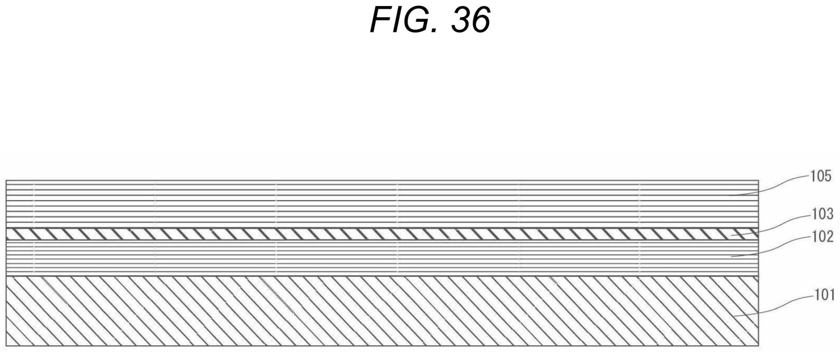

Hereinafter, an example of a method for manufacturing the surface emitting device SLD including the surface emitting element 110 will be described with reference to the flowchart of Fig. 35 and cross-sectional views (Figs. 36 to 42) corresponding to Fig. 31 for each manufacturing process of the surface emitting element 110. As overall flow, first, a plurality of surface emitting devices SLD each including the surface emitting element 110 is simultaneously generated on one wafer (hereinafter, referred to as the "substrate 101" for convenience) which is a base material of the substrate 101 by a semiconductor manufacturing method using a semiconductor manufacturing device. Next, the plurality of continuous integrated surface emitting devices SLD is separated from each other by dicing to obtain a chip-shaped surface emitting device SLD.

In the first step S11, a stacked body is generated (see Fig. 36). Specifically, for example, the first semiconductor multilayer film reflector 102, the light emitting layer 103, and the second semiconductor multilayer film reflector 105 are stacked in this order on the substrate 101 as a growth substrate by an epitaxial crystal growth method such as a metal organic chemical vapor deposition (MOCVD) method to generate a stacked body. In this event, as raw materials of the compound semiconductor, for example, a methyl-based organometallic gas such as trimethylaluminum (TMAl), trimethylgallium (TMGa), or trimethylindium (TMIn) and an arsine (AsH₃) gas are used, as raw materials of donor impurities, for example, disilane (Si₂H₆) is used, and as raw materials of acceptor impurities, for example, carbon tetrabromide (CBr₄) is used.

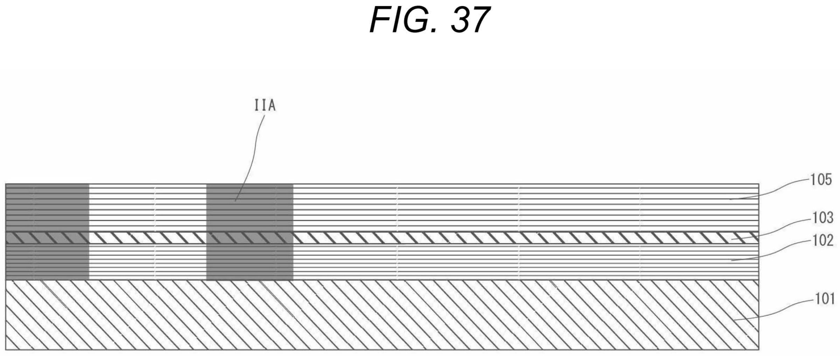

Next, in step S12, the ion implantation region IIA is formed (see Fig. 37). Specifically, a resist pattern covering a portion other than a portion where the ion implantation region IIA is to be formed on the upper surface (upper surface of the second semiconductor multilayer film reflector 105) of the stacked body is formed, and ion implantation is performed using the resist pattern as a mask. The implantation depth of the ions at this time is set to a level until the ions reach the upper surface of the substrate 101.

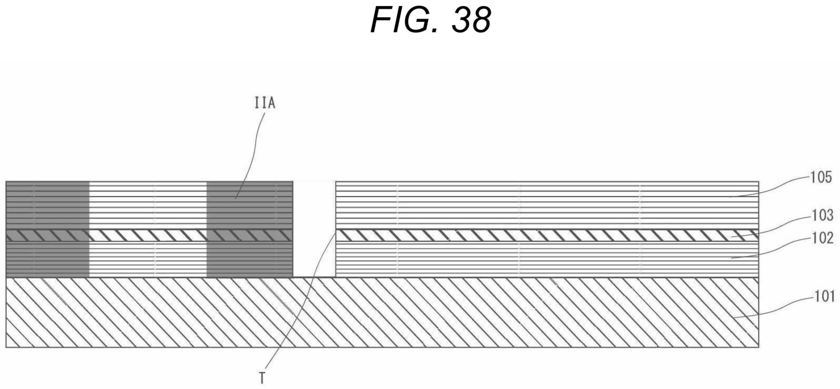

In the next step S13, the trench T is formed (see Fig. 38). Specifically, a resist pattern covering a portion other than a portion where the trench T is to be formed on the upper surface (upper surface of the second semiconductor multilayer film reflector 105) of the stacked body is formed, and the stacked body is etched by dry etching or wet etching using the resist pattern as a mask. The etching depth at this time is set to a level until the etching bottom surface reaches the upper surface of the substrate 101.

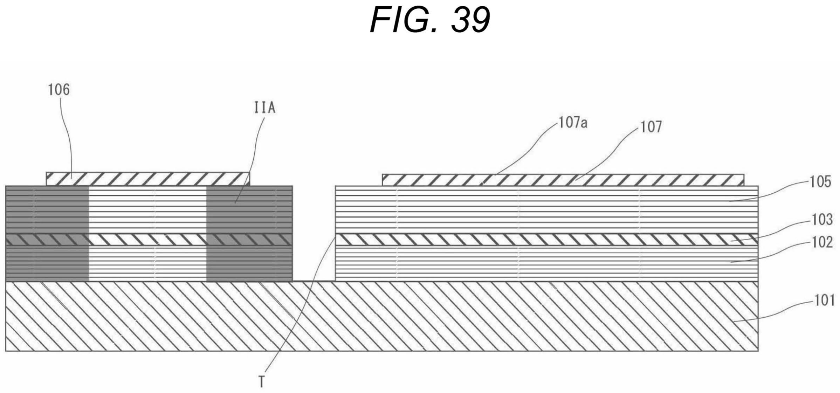

In the next step S14, the anode electrode 106 and the cathode electrode 107 are formed (see Fig. 39). Specifically, for example, by a lift-off method, the anode electrode 106 is formed in a solid shape on the light emitting element constituent portion LEC, and the cathode electrode 107 is formed in a solid shape on the dummy element constituent portion DEC. In this event, for example, vapor deposition, sputtering, or the like, is used for forming an electrode material.

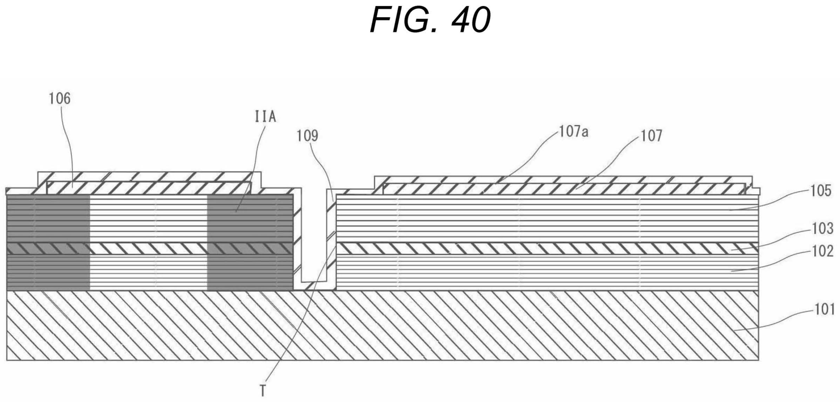

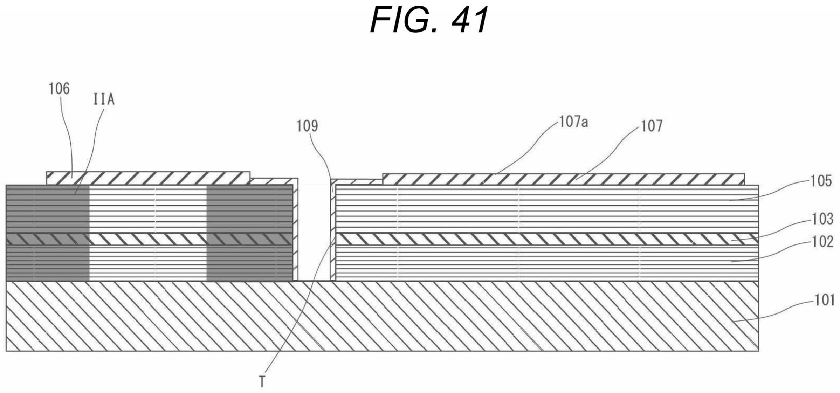

In the next step S15, the insulating film 109 is formed. Specifically, first, the insulating film 109 is formed on the entire surface (see Fig. 40). Next, the insulating film 109 other than the insulating film 109 covering the side surface of the trench T and the region around the opening end is removed by photolithography and etching to expose the anode electrode 106, the cathode electrode 107, and the bottom surface of the trench T (upper surface of the substrate 101) (see Fig. 41).

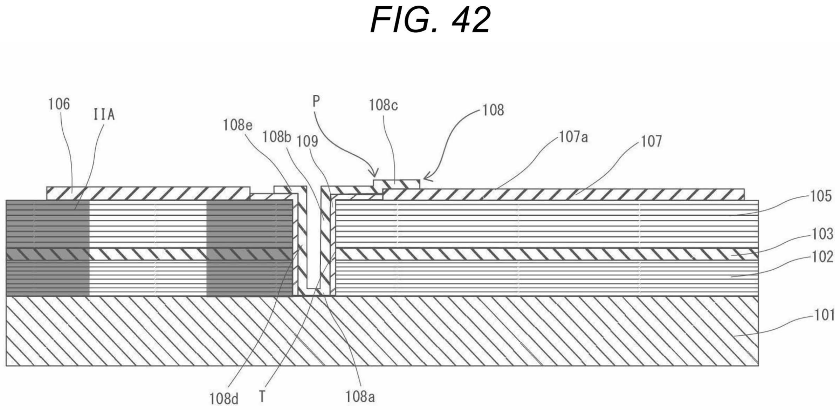

In the last step S16, the wiring 108 is formed (see Fig. 42). Specifically, for example, by a lift-off method, the first wiring portion 108a covers the upper surface of the substrate 101, the second wiring portion 108b is formed along the insulating film 109 covering the side surface of the proximity portion of the dummy element constituent portion DEC on the side of the light emitting element constituent portion LEC, an end portion of the third wiring portion 108c is located on an end portion of the cathode electrode 107 on the side of the proximity portion, the fourth wiring portion 108d is formed along the insulating film 109 covering the side surface of the light emitting element constituent portion LEC on the side of the dummy element constituent portion DEC, and the fifth wiring portion 108e is formed along the insulating film 109 covering the upper surface of the light emitting element constituent portion LEC. In this event, for example, vapor deposition, sputtering, or the like, is used for forming an electrode material.

### <<Effects of Surface Emitting Element>>

According to the surface emitting element 110, effects substantially similar to those of the surface emitting element 10 are obtained.

### <12. Surface Emitting Element According to Example 12 of One Embodiment of Present Technology>

### <<Configuration of Surface Emitting Element>>

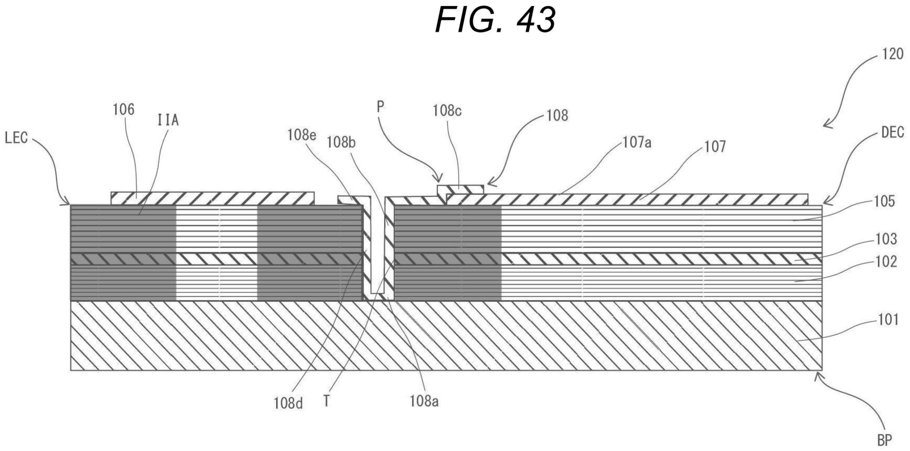

Fig. 43 is a cross-sectional view of a surface emitting element 120 according to Example 12 of one embodiment of the present technology.

The surface emitting element 120 has a configuration similar to that of the surface emitting element 110 according to Example 11 except that the ion implantation region IIA is also provided to surround the trench T, and the wiring 108 is also directly provided on the side surface of the trench T and the region around the opening end.

In the surface emitting element 120, the insulating film 109 is not provided, and the region around the side surface and the opening end of the trench T is insulated from the wiring 108 by the ion implantation region IIA.

According to the surface emitting element 120, effects similar to those of the surface emitting element 110 according to Example 11 are obtained, and the insulating film 109 is unnecessary, so that the configuration can be simplified and the manufacturing process can be simplified.

### <13. Surface Emitting Element According to Example 13 of One Embodiment of Present Technology>

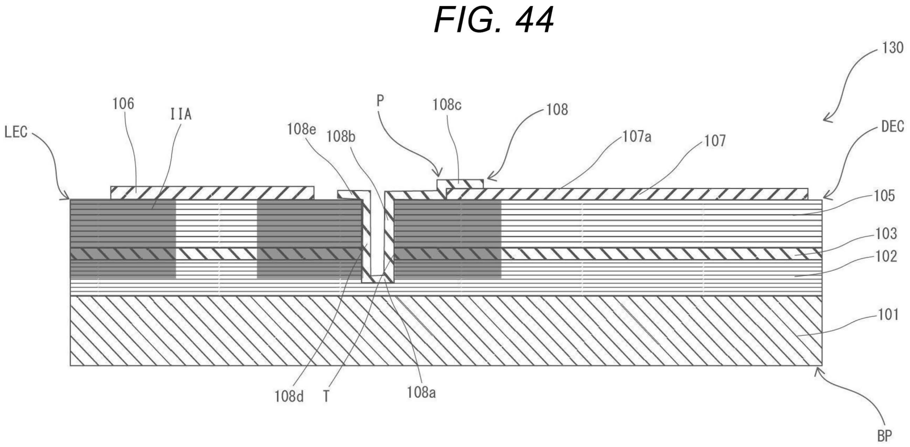

Fig. 44 is a cross-sectional view of a surface emitting element 130 according to Example 13 of one embodiment of the present technology.

The surface emitting element 130 has a configuration similar to that of the surface emitting element 120 according to Example 12 except that the bottom surface of the trench T is located in the first semiconductor multilayer film reflector 102.

In the surface emitting element 130, the ion implantation region IIA is not provided below the first semiconductor multilayer film reflector 102, and a lateral current path is formed below the first semiconductor multilayer film reflector 102. In the surface emitting element 130, a semi-insulating substrate (such as, for example, an i-GaAs substrate and a semi-insulating (SI)-GaAs substrate) can also be used as the substrate 101.

According to the surface emitting element 130, effects similar to those of the surface emitting element 120 can be obtained, series resistance can be reduced, and low power consumption can be achieved.

### <14. Modifications of Present Technology>

The present technology is not limited to the above examples of one embodiment, and can be appropriately changed.

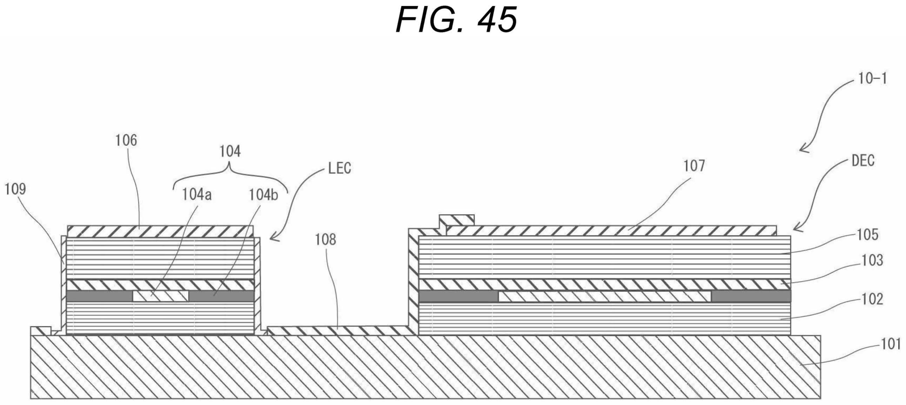

For example, as in a surface emitting element 10-1 according to Modification 1 of Example 1 of one embodiment illustrated in Fig. 45, a positional relationship between the light emitting layer 103 and the oxidation confinement layer 104 may be reverse to that in the surface emitting element 10 according to Example 1 (the oxidation confinement layer 104 is arranged on the side of the substrate 101 of the light emitting layer 103).

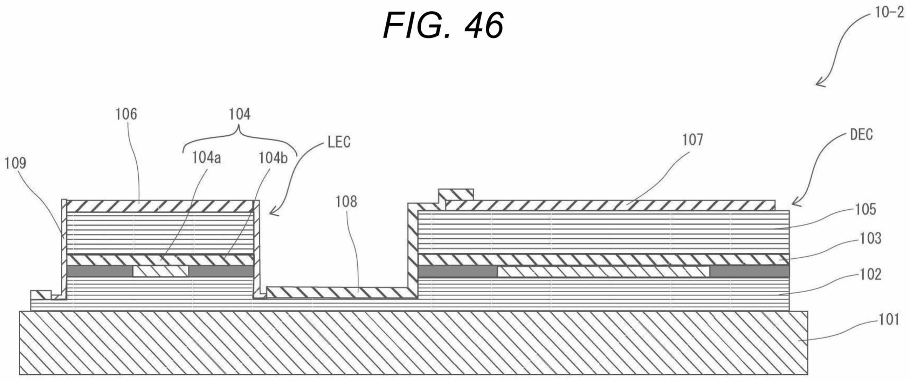

For example, as in a surface emitting element 10-2 according to Modification 2 of Example 1 of one embodiment illustrated in Fig. 46, the base portion BP may include the substrate 101 and a portion (lower portion) of the first semiconductor multilayer film reflector 102. In the surface emitting element 10-2, each of the light emitting element constituent portion LEC and the dummy element constituent portion DEC includes the other portion (upper portion) of the first semiconductor multilayer film reflector 102, the oxidation confinement layer 104, the light emitting layer 103, and the second semiconductor multilayer film reflector 105. In the surface emitting element 10-2, a portion of the wiring 108 is provided on the first semiconductor multilayer film reflector 102, and a current path is formed below the first semiconductor multilayer film reflector 102. Thus, a semi-insulating substrate (such as, for example, an i-GaAs substrate and a semi-insulating (SI)-GaAs substrate) can also be used as the substrate 101.

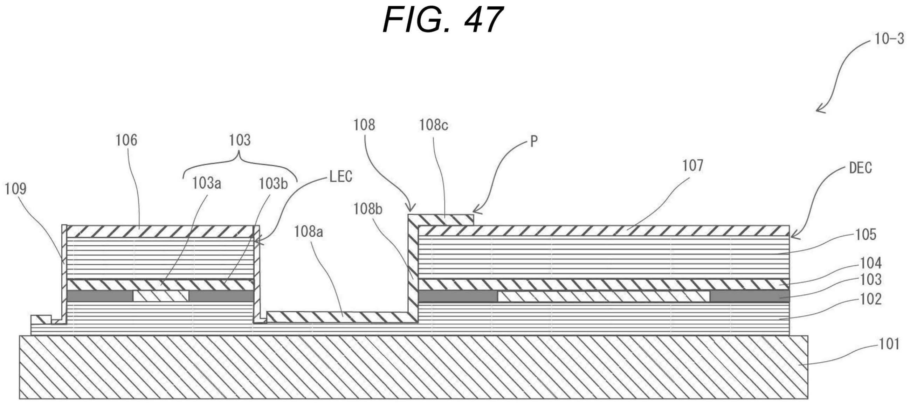

For example, as in the surface emitting element 10-3 according to Modification 3 of Example 1 of one embodiment illustrated in Fig. 47, the cathode electrode 107 may be provided on the entire top of the dummy mesa, and the entire third wiring portion 108c of the wiring 108 may be positioned on the cathode electrode 107 to constitute the convex portion P.

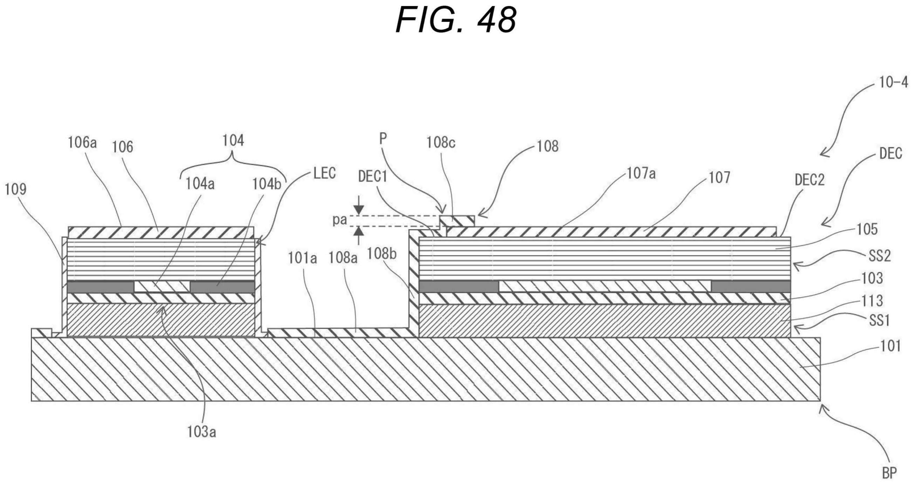

For example, as in a surface emitting element 10-4 according to Modification 4 of Example 1 of one embodiment illustrated in Fig. 48, a cladding layer 113 (for example, an n-AlGaAs layer) may be provided instead of the first semiconductor multilayer film reflector 102 to constitute a backside emission type high-output light emitting diode (LED).

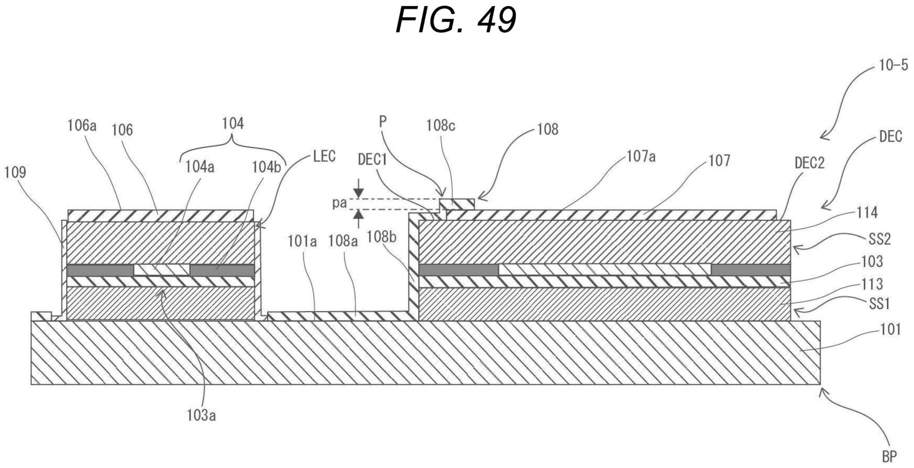

For example, as in a surface emitting element 10-5 according to Modification 5 of Example 1 of one embodiment illustrated in Fig. 49, a cladding layer 113 (for example, an n-AlGaAs layer) may be provided instead of the first semiconductor multilayer film reflector 102 and a cladding layer 114 (for example, a p-AlGaAs layer) may be provided instead of the second semiconductor multilayer film reflector 105 to constitute a backside emission type light emitting diode (LED).

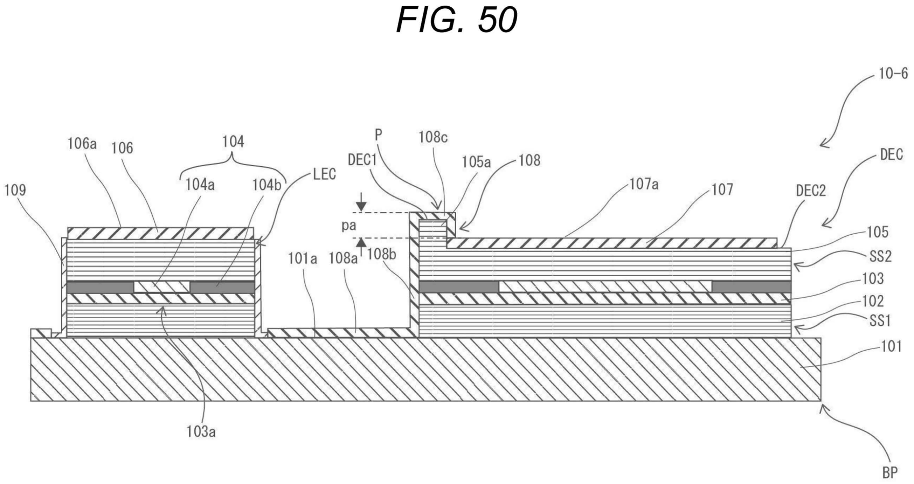

For example, as in the surface emitting element 10-6 (VCSEL) according to Modification 6 of Example 1 of one embodiment illustrated in Fig. 50, the ridge 105a provided in the second semiconductor multilayer film reflector 105 (second semiconductor structure SS2) of the proximity portion DEC1 of the dummy element constituent portion DEC may constitute at least a portion of the convex portion P. Here, the ridge 105a and the third wiring portion 108c constitute the convex portion P. Note that a position of the ridge 105a may be shifted to a side of the remote portion DEC2 to constitute the convex portion P only with the ridge 105a.

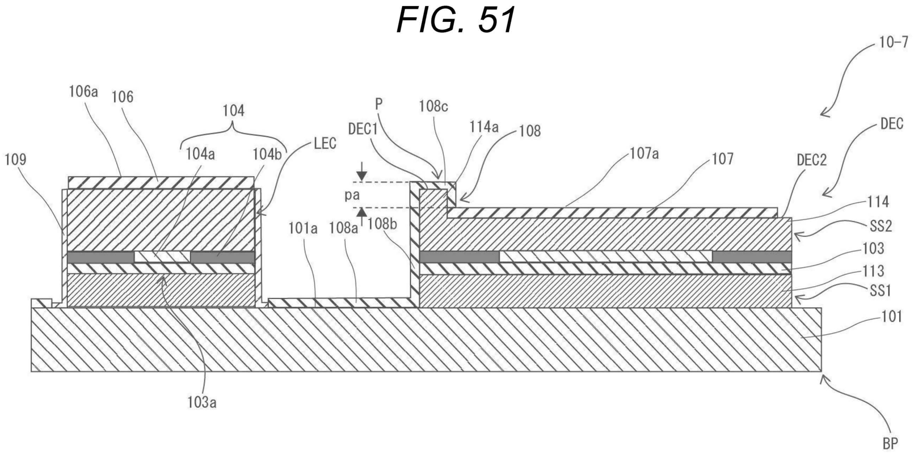

For example, as in the surface emitting element 10-7 (LED) according to Modification 7 of Example 1 of one embodiment illustrated in Fig. 51, the ridge 114a provided in the cladding layer 114 (second semiconductor structure SS2) of the proximity portion DEC1 of the dummy element constituent portion DEC may constitute at least a portion of the convex portion P. Here, the ridge 114a and the third wiring portion 108c constitute the convex portion P.

In each of the above examples and modifications, the surface emitting element may have a contact layer (highly doped semiconductor layer) in ohmic contact with the electrode on the uppermost layer of the light emitting element constituent portion LEC.

In each of the above examples and modifications, the surface emitting element may have a contact layer (highly doped semiconductor layer) in ohmic contact with the wiring 108 between the substrate 101 and the first semiconductor multilayer film reflector 102.

The oxidation confinement layer 104 may be provided, for example, in the first semiconductor multilayer film reflector 102 and/or the second semiconductor multilayer film reflector 105.

In each of the above-described examples and modifications, in the light emitting element constituent portion array LECA of the surface emitting element, the light emitting element constituent portions LEC may be arranged in one dimension or in two dimensions other than in a matrix (such as, for example, houndstooth arrangement and random arrangement).

For example, the current confinement in the surface emitting element is not limited to the current confinement by the oxidation confinement layer 104 or the ion implantation region IIA. For example, the current confinement may be performed by a QWI that provides a bandgap energy difference between the inside and outside of an aperture by Ga vacancy diffusion to confine carriers, a tunnel junction, a buried tunnel junction, or the like. A plurality of current confinement structures may be used in combination. For example, the non-oxidized region 104a of the oxidation confinement layer 104 may be surrounded by the ion implantation region IIA.

For example, the substrate 101 may be a Si substrate, a Ge substrate, a GaN substrate, an InP substrate, or the like. In any case, the semiconductor layer to be stacked on the substrate 101 is preferably appropriately selected so as to be lattice-matched with the material of the substrate 101. For the surface emitting element, a material having any emission wavelength included in the wavelength band of 200 to 2000 nm can be used.

The light emitting constituent portion is not limited to the semiconductor multilayer film reflector, and may include a reflector including one or a combination of two or more selected from a semiconductor, a dielectric, and a metal.

In the surface emitting element of each of the above examples and modifications, the conductivity types (p-type and n-type) of the first and second semiconductor structures may be reversed. In this case, a positional relationship between the anode electrode and the cathode electrode needs to be reversed.

Part of the configurations of the surface emitting element according to the above-described examples and modifications may be combined within a range not contradictory to each other.

In each of the examples, and modifications, the material, conductivity type, thickness, width, shape, size, and the like, of each layer constituting the surface emitting element can be appropriately changed within a range functioning as the surface emitting element.

### <15. Application Example to Electronic Equipment>

The technology according to the present disclosure (the present technology) can be applied to various products (electronic equipment). For example, the technology according to the present disclosure may be implemented as any type of moving body such as an automobile, an electric vehicle, a hybrid electric vehicle, a motorcycle, a bicycle, a personal mobility, an airplane, a drone, a ship, or a robot, or as an apparatus mounted on low power consumption equipment (for example, a smartphone, a smartwatch, a tablet, a mouse, or the like).

The surface emitting element according to the present technology can also be applied as, for example, a light source of equipment (for example, a printer, a copier, a projector, a head-mounted display, a head-up display, or the like) that forms or displays an image by light.

### <16. Example in which Surface Emitting Element is Applied to Distance Measurement Device>

Hereinafter, an application example of the surface emitting element 10 according to the first embodiment will be described.

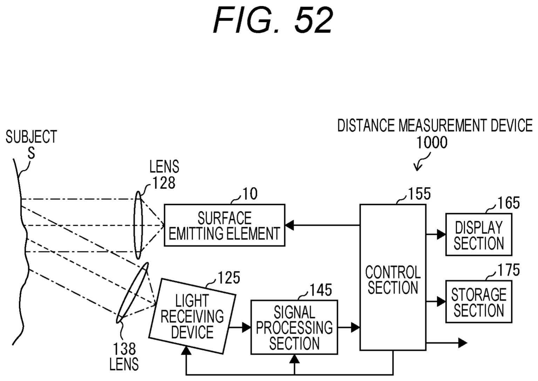

Fig. 52 illustrates an example of a schematic configuration of a distance measurement device 1000 (ranging device) including the surface emitting element 10 as an example of electronic equipment according to the present technology. The distance measurement device 1000 measures a distance to a subject S by a time of flight (TOF) method. The distance measurement device 1000 includes the surface emitting element 10. The distance measurement device 1000 includes, for example, the surface emitting element 10, a light receiving device 125, lenses 128, 138, a signal processing section 145, a control section 155, a display section 165, and a storage section 175.

The light receiving device 125 receives the light emitted from the surface emitting element 10 and reflected by the subject S (object). In other words, the light receiving device 125 detects the light reflected by the subject S. The lens 128 is a lens for collimating the light emitted from the surface emitting element 10, and is, for example, a collimating lens. The lens 138 is a lens for collecting light reflected by the subject S and guiding the light to the light receiving device 125, and is, for example, a condenser lens.

The signal processing section 145 is a circuit for generating a signal corresponding to a difference between a signal input from the light receiving device 125 and a reference signal input from the control section 155. The control section 155 includes, for example, a time to digital converter (TDC). The reference signal may be a signal input from the control section 155, or may be an output signal of a detection section that directly detects the output of the surface emitting element 10. The control section 155 is, for example, a processor that controls the surface emitting element 10, the light receiving device 125, the signal processing section 145, the display section 165, and the storage section 175. The control section 155 is a circuit that measures the distance to the subject S on the basis of the signal generated by the signal processing section 145. The control section 155 generates a video signal for displaying information on the distance to the subject S, and outputs the video signal to the display section 165. The display section 165 displays information on the distance to the subject S on the basis of the video signal input from the control section 155. The control section 155 stores information on the distance to the subject S in the storage section 175.

In the present application example, instead of the surface emitting element 10, any one of the above-described surface emitting elements 10-1, 10-2, 10-3, 10-4, 10-5, 10-6, 10-7, 20, 30, 40, 50, 60, 70, 80, 90, 100, 110, 120, 130 can be applied to the distance measurement device 1000.

### <17. Example in which Distance Measurement Device is Mounted on Moving Body>

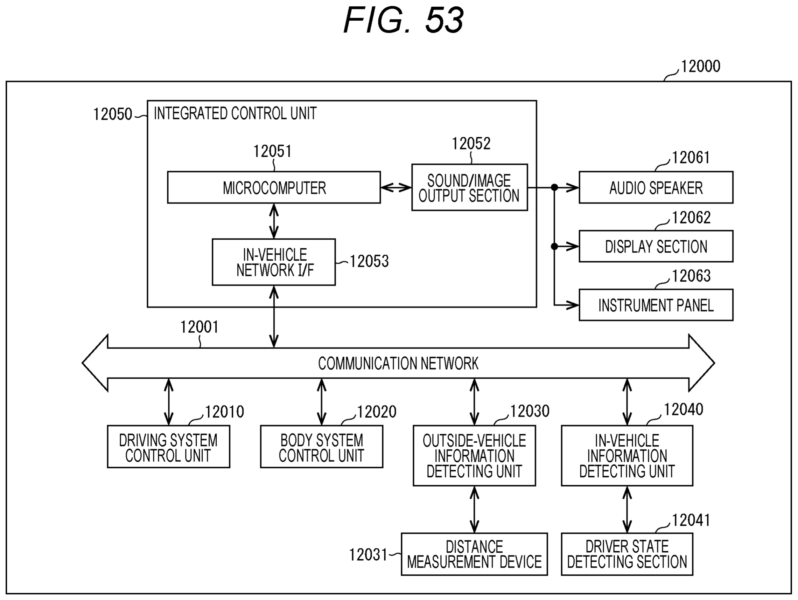

Fig. 53 is a block diagram illustrating a schematic configuration example of a vehicle control system which is an example of a mobile entity control system to which the technology of the present disclosure is applicable.

The vehicle control system 12000 includes a plurality of electronic control units connected to each other via a communication network 12001. In the example illustrated in Fig. 53, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and an in-vehicle network interface (I/F) 12053 are illustrated as functional configurations of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine or a driving motor, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various lamps such as a headlamp, a back-up lamp, a brake lamp, a turn indicator, or a fog lamp. In this case, a radio wave transmitted from a mobile device that substitutes for a key or signals of various switches may be input to the body system control unit 12020. The body system control unit 12020 receives these input radio waves or signals, and controls a door lock device, the power window device, the lamps, or the like, of the vehicle.

The outside-vehicle information detecting unit 12030 detects information about the outside of the vehicle including the vehicle control system 12000. For example, a distance measurement device 12031 is connected to the outside-vehicle information detecting unit 12030. The distance measurement device 12031 includes the distance measurement device 1000 described above. The outside-vehicle information detecting unit 12030 causes the distance measurement device 12031 to measure a distance to an object (subject S) outside the vehicle, and acquires distance data acquired by the measurement. The outside-vehicle information detecting unit 12030 may perform processing of detecting a person, a car, an obstacle, a sign, or the like, on the basis of the acquired distance data.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether or not the driver is dozing.

The microcomputer 12051 can calculate a control target value for the driving force generating device, the steering mechanism, or the braking device on the basis of the information about the inside or outside of the vehicle, the information being obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS), the functions including vehicle collision avoidance or shock mitigation, following driving based on the following distance, vehicle speed maintaining driving, vehicle collision warning, vehicle lane departure warning, and the like.

Furthermore, the microcomputer 12051 can perform cooperative control intended for automated driving, which makes the vehicle travel automatedly without depending on the operation of the driver, or the like, by controlling the driving force generating device, the steering mechanism, the braking device, or the like on the basis of the information about the surroundings of the vehicle, the information being obtained by the outside-vehicle information detecting unit 12030 or the in-vehicle information detecting unit 12040.

In addition, the microcomputer 12051 can output a control command to the body system control unit 12020 on the basis of the information about the outside of the vehicle obtained by the outside-vehicle information detecting unit 12030. For example, the microcomputer 12051 can perform cooperative control intended to prevent glare by controlling the headlamp to switch from high beam to low beam, for example, in accordance with the position of a preceding vehicle or an oncoming vehicle detected by the outside-vehicle information detecting unit 12030.

The sound/image output section 12052 transmits an output signal of at least one of a sound or an image to an output device capable of visually or auditorily notifying an occupant of the vehicle or the outside of the vehicle of information. In the example illustrated in Fig. 53, an audio speaker 12061, a display section 12062, and an instrument panel 12063 are illustrated as the output device. The display section 12062 may, for example, include at least one of an on-board display or a head-up display.

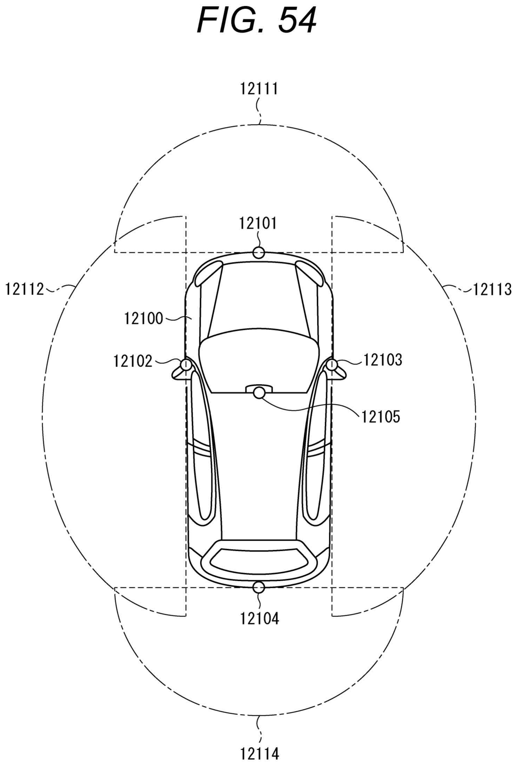

Fig. 54 is a view illustrating an example of installation positions of the distance measurement device 12031.

In Fig. 54, a vehicle 12100 includes distance measurement devices 12101, 12102, 12103, 12104, 12105 as the distance measurement device 12031.

For example, the distance measurement devices 12101, 12102, 12103, 12104, 12105 are provided at positions such as a front nose, sideview mirrors, a rear bumper, a back door, an upper portion of a windshield in a vehicle interior, and the like, of the vehicle 12100. The distance measurement device 12101 provided at the front nose and the distance measurement device 12105 provided at the upper portion of the windshield in the vehicle interior mainly acquire data of the front side of the vehicle 12100. The distance measurement devices 12102 and 12103 provided at the sideview mirrors mainly acquire data of the sides of the vehicle 12100. The distance measurement device 12104 provided at the rear bumper or the back door mainly acquires data of the rear side of the vehicle 12100. The data of the front side acquired by the distance measurement devices 12101 and 12105 is mainly used to detect a preceding vehicle, a pedestrian, an obstacle, a traffic light, a traffic sign, or the like.

Note that Fig. 54 illustrates an example of detection ranges of the distance measurement devices 12101 to 12104. A detection range 12111 indicates a detection range of the distance measurement device 12101 provided at the front nose, detection ranges 12112 and 12113 indicate detection ranges of the distance measurement devices 12102 and 12103 provided at the sideview mirrors, respectively, and a detection range 12114 indicates a detection range of the distance measurement device 12104 provided at the rear bumper or the back door.

For example, the microcomputer 12051 may obtain a distance to each three-dimensional object within the detection ranges 12111 to 12114 and a temporal change in the distance (relative speed with respect to the vehicle 12100) on the basis of the distance data obtained from the distance measurement devices 12101 to 12104, whereby particularly the nearest three-dimensional object present on a traveling path of the vehicle 12100, which travels in substantially the same direction as the vehicle 12100 at a predetermined speed (for example, equal to or more than 0 km/h), may be extracted as a preceding vehicle. Moreover, the microcomputer 12051 can set a following distance to be maintained relative to a preceding vehicle in advance, and perform automatic brake control (including following stop control), automatic acceleration control (including following start control), or the like. It is therefore possible to perform cooperative control intended for automated driving in which the vehicle travels autonomously without depending on the driver's operation, or the like.

For example, on the basis of the distance data obtained from the distance measurement devices 12101 to 12104, the microcomputer 12051 can extract three-dimensional object data regarding three-dimensional objects while classifying into two-wheeled vehicles, standard-sized vehicles, large-sized vehicles, pedestrians, and other three-dimensional objects such as utility poles, and use the three-dimensional object data for automatic avoidance of obstacles. For example, the microcomputer 12051 identifies obstacles around the vehicle 12100 as obstacles that the driver of the vehicle 12100 can recognize visually and obstacles that are difficult for the driver of the vehicle to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

An example of the moving body control system to which the technology according to the present disclosure can be applied has been described above. The technology according to the present disclosure may be applied to the distance measurement device 12031 in the configuration described above.

Furthermore, the present technology may also adopt the following configurations.
(1) A surface emitting element including:
   a base portion including a substrate; and
   a light emitting element constituent portion and a dummy element constituent portion provided to be spaced apart in an in-plane direction on one surface of the base portion,
   in which an electrode including an external connection surface is provided on the dummy element constituent portion, and
   a convex portion protruding to a side opposite to a side of the base portion more than the external connection surface is provided in a proximity portion relatively close to the light emitting element constituent portion, of the dummy element constituent portion.
(2) The surface emitting element according to (1), in which the external connection surface is a flat surface.
(3) The surface emitting element according to (1) or (2), in which a wiring that covers a portion of the one surface and the proximity portion is provided.
(4) The surface emitting element according to (3), in which the wiring includes at least a portion of the convex portion.
(5) The surface emitting element according to any one of (1) to (4), in which the electrode includes at least a portion of the convex portion.
(6) The surface emitting element according to any one of (1) to (5), in which the external connection surface is continuously provided from the proximity portion to a remote portion relatively far from the light emitting element constituent portion, of the dummy element constituent portion.
(7) The surface emitting element according to any one of (1) to (6), in which at least a portion from the proximity portion to a remote portion relatively far from the light emitting element constituent portion, of the dummy element constituent portion is covered with a protective film.
(8) The surface emitting element according to any one of (1) to (7),
   in which the wiring is covered with a protective film, and
   the convex portion includes a portion of the protective film.
(9) The surface emitting element according to any one of (3) to (8), in which the wiring includes
   a first wiring provided on the portion and
   a second wiring provided on the first wiring.
(10) The surface emitting element according to (9), in which the second wiring includes conductive plating.
(11) The surface emitting element according to any one of (1) to (10), in which another electrode is provided on the light emitting element constituent portion, and the electrode and the other electrode have the same height of a surface on a side opposite to the side of the base portion.
(12) The surface emitting element according to any one of (1) to (11), in which both the light emitting element constituent portion and the dummy element constituent portion have a mesa shape.
(13) The surface emitting element according to any one of (1) to (12), in which each of the light emitting element constituent portion and the dummy element constituent portion includes:
   at least a portion of a first semiconductor structure arranged on the substrate;
   a light emitting layer arranged on the first semiconductor structure; and
   a second semiconductor structure arranged on the light emitting layer.
(14) The surface emitting element according to (13), in which the light emitting element constituent portion includes a current confinement region provided between a surface of the first semiconductor structure on a side opposite to the side of the light emitting layer and the light emitting layer and/or between a surface of the second semiconductor structure on the side opposite to the side of the light emitting layer and the light emitting layer.
(15) The surface emitting element according to of (13) or (14), in which at least one of the first semiconductor structure or the second semiconductor structure includes a semiconductor multilayer film reflector.
(16) The surface emitting element according to any one of (1) to (15), in which the surface emitting element emits light to a side opposite to a side of the light emitting element constituent portion of the base portion.
(17) The surface emitting element according to any one of (3) to (16),
   in which a plurality of at least the light emitting element constituent portions out of the light emitting element constituent portion and the dummy element constituent portion is provided, and
   the wiring is a common wiring common to at least two of the light emitting element constituent portions.
(18) A light source device including:
   surface emitting element including a base portion including a substrate, and
   a light emitting element constituent portion and a dummy element constituent portion provided to be spaced apart from each other in an in-plane direction on one surface of the base portion, in which an electrode including an external connection surface is provided on the dummy element constituent portion, and
   a convex portion protruding to a side opposite to a side of the base portion more than the external connection surface is provided in a proximity portion relatively close to the light emitting element constituent portion, of the dummy element constituent portion; and
   another substrate,
   in which another electrode is provided on the light emitting element constituent portion,
   the other electrode and the other substrate are bonded to each other via a first bump, and
   the electrode and the other substrate are bonded to each other via a second bump.
(19) The light source device according to (18), in which a plurality of the second bumps is provided.
(20) A surface emitting element including:
   a base portion including a substrate; and
   a light emitting element constituent portion and a dummy element constituent portion provided to be spaced apart in an in-plane direction on one surface of the base portion,
   in which an electrode including an external connection surface is provided on the dummy element constituent portion, and
   a convex portion protruding to a side opposite to a side of the base portion more than the external connection surface is provided in a proximity portion relatively close to the light emitting element constituent portion, of the dummy element constituent portion.
(21) The surface emitting element according to any one of (3) to (17), in which the wiring does not cover a portion other than the proximity portion of the dummy element constituent portion.
(22) The surface emitting element according to any one of (1) to (21), in which the proximity portion includes at least a portion of the convex portion.

### REFERENCE SIGNS LIST

10, 10-1, 10-2, 10-3, 10-4, 10-5, 10-6, 10-7, 20, 30, 40, 50, 60, 70, 80, 90, 100, 110, 120, 130 Surface emitting element
101 Substrate
101a Upper surface of substrate (one surface of base portion)
102 First semiconductor multilayer film reflector (first semiconductor structure)
103 Light emitting layer
104b Oxidation confinement region (current confinement region)
105 Second semiconductor multilayer film reflector (second semiconductor structure)
106 Anode electrode (another electrode)
107 Cathode electrode (electrode)
107a External connection surface
108 Wiring
108A First wiring
108B Second wiring
109 Insulating film (protective film)
111 Insulating film (protective film)
112 Another member (at least a portion of convex portion)
113 Cladding layer (first semiconductor structure)
114 Cladding layer (second semiconductor structure)
BP Base portion
LEC Light emitting element constituent portion
DEC Dummy element constituent portion
DEC1 Proximity portion
DEC2 Remote portion
P Convex portion
SS1 First semiconductor structure
SS2 Second semiconductor structure

## Claims

1. A surface emitting element comprising:
a base portion including a substrate; and
a light emitting element constituent portion and a dummy element constituent portion provided to be spaced apart in an in-plane direction on one surface of the base portion,
wherein an electrode including an external connection surface is provided on the dummy element constituent portion, and
a convex portion protruding to a side opposite to a side of the base portion more than the external connection surface is provided in a proximity portion relatively close to the light emitting element constituent portion, of the dummy element constituent portion.

2. The surface emitting element according to claim 1, wherein the external connection surface is a flat surface.

3. The surface emitting element according to claim 1, wherein a wiring that covers a portion of the one surface and the proximity portion is provided.

4. The surface emitting element according to claim 3, wherein the wiring includes at least a portion of the convex portion.

5. The surface emitting element according to claim 1, wherein the electrode includes at least a portion of the convex portion.

6. The surface emitting element according to claim 1, wherein the proximity portion includes at least a portion of the convex portion.

7. The surface emitting element according to claim 2, wherein the external connection surface is continuously provided from the proximity portion to a remote portion relatively far from the light emitting element constituent portion, of the dummy element constituent portion.

8. The surface emitting element according to claim 7, wherein at least the remote portion is covered with a protective film.

9. The surface emitting element according to claim 1,
wherein the wiring is covered with a protective film, and
the convex portion includes a portion of the protective film.

10. The surface emitting element according to claim 3, wherein the wiring includes
a first wiring provided on the portion and
a second wiring provided on the first wiring.

11. The surface emitting element according to claim 10, wherein the second wiring includes conductive plating.

12. The surface emitting element according to claim 1,
wherein another electrode is provided on the light emitting element constituent portion, and
the electrode and the other electrode have the same height of a surface on a side opposite to the side of the base portion.

13. The surface emitting element according to claim 1, wherein both the light emitting element constituent portion and the dummy element constituent portion have a mesa shape.

14. The surface emitting element according to claim 1, wherein each of the light emitting element constituent portion and the dummy element constituent portion includes:
at least a portion of a first semiconductor structure arranged on the substrate;
a light emitting layer arranged on the first semiconductor structure; and
a second semiconductor structure arranged on the light emitting layer.

15. The surface emitting element according to claim 14, wherein the light emitting element constituent portion includes a current confinement region provided between a surface of the first semiconductor structure on a side opposite to the side of the light emitting layer and the light emitting layer and/or between a surface of the second semiconductor structure on a side opposite to the side of the light emitting layer and the light emitting layer.

16. The surface emitting element according to claim 14, wherein at least the second semiconductor structure out of the first semiconductor structure and the second semiconductor structure includes a semiconductor multilayer film reflector.

17. The surface emitting element according to claim 1, wherein the surface emitting element emits light to a side opposite to a side of the light emitting element constituent portion of the base portion.

18. The surface emitting element according to claim 3,
wherein a plurality of at least the light emitting element constituent portions out of the light emitting element constituent portion and the dummy element constituent portion is provided, and
the wiring is a common wiring common to at least two of the light emitting element constituent portions.

19. A light source device comprising: a surface emitting element including: a base portion including a substrate; and a light emitting element constituent portion and a dummy element constituent portion provided to be spaced apart from each other in an in-plane direction on one surface of the base portion, in which an electrode including an external connection surface is provided on the dummy element constituent portion, and a convex portion protruding to a side opposite to a side of the base portion more than the external connection surface is provided in a proximity portion relatively close to the light emitting element constituent portion, of the dummy element constituent portion; and
another substrate,
wherein another electrode is provided on the light emitting element constituent portion,
the other electrode and the other substrate are bonded to each other via a first bump, and
the electrode and the other substrate are bonded to each other via a second bump.

20. The light source device according to claim 19, wherein a plurality of the second bumps is provided.
